(19) Europäisches Patentamt / European Patent Office / Office européen des brevets

(11) **EP 4 786 162 A1**

(12) **EUROPEAN PATENT APPLICATION**
published in accordance with Art. 153(4) EPC

(43) Date of publication:
05.08.2026 Bulletin 2026/32

(21) Application number: 24872522.8

(22) Date of filing: 27.09.2024

(51) International Patent Classification (IPC):
*B32B 9/00* (2006.01)     *B32B 7/12* (2006.01)
*B32B 9/04* (2006.01)     *C23C 14/08* (2006.01)
*G02B 5/30* (2006.01)

(52) Cooperative Patent Classification (CPC):
B32B 7/12; B32B 9/00; B32B 9/04; C23C 14/08;
G02B 5/30

(86) International application number:
PCT/JP2024/034697

(87) International publication number:
WO 2025/070741 (03.04.2025 Gazette 2025/14)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 29.09.2023 JP 2023169145
01.07.2024 JP 2024106165

(71) Applicant: Dai Nippon Printing Co., Ltd.
Tokyo 162-8001 (JP)

(72) Inventors:
• MORIMOTO Taro
  Tokyo 162-8001 (JP)

• SHIBATA Takafumi
  Tokyo 162-8001 (JP)
• MIZOSHIRI Makoto
  Tokyo 162-8001 (JP)
• SAKAMOTO Takeshi
  Tokyo 162-8001 (JP)
• TAMURA Syuichi
  Tokyo 162-8001 (JP)
• HARUKI Akihito
  Tokyo 162-8001 (JP)

(74) Representative: Beck Greener LLP
Fulwood House
12 Fulwood Place
London WC1V 6HR (GB)

(54) **BARRIER FILM, MULTILAYER OBJECT, WAVELENGTH CONVERSION SHEET, BACKLIGHT MEMBER, AND DISPLAY DEVICE**

(57) Provided are: a barrier film which, when used in a wavelength conversion sheet, can attain both a high retention of luminance and a reduction in unevenness of color; and a wavelength conversion sheet and a backlight member using the same. In the barrier film, a resin substrate, a first vapor-deposited aluminum oxide film, a first coating layer, a second vapor-deposited aluminum oxide film, and a second coating layer are laminated in this order, wherein the first and second coating layers are each a cured product of a resin composition containing alkoxysilane and a hydroxyl-group-containing water-soluble resin, and the first and second vapor-deposited aluminum oxide films exhibit a vapor-deposited-film peak top ratio P of 1.05-1.60 when X-ray absorption fine structure analysis is performed. P = (intensity peak top at around 1,572 eV) / (intensity peak top at around 1,566 eV)

FIG. 1

**Description**

TECHNICAL FIELD

The present invention relates to a barrier film, a laminate, a wavelength conversion sheet, a backlight member, and a display device.

BACKGROUND ART

Conventionally, a laminated film including a film formed on a base material such as a long film or sheet made of plastic or the like has been used for a variety of purposes. For example, a barrier laminated film provided with a barrier function against oxygen and water vapor by providing a barrier layer composed of a thin film of aluminum oxide or the like on a plastic film has been developed.

As a method for manufacturing a barrier film provided with an aluminum oxide thin film, for example, Patent Document 1 discloses a method for obtaining a gas barrier film having excellent transparency and gas barrier property by using plasma activated deposition (so-called plasma-assisted method during vapor deposition) that generates high-density plasma in a space between the evaporation source of aluminum and a polymer film.

Patent Document 2 describes that in a method of manufacturing a gas barrier film including an aluminum oxide deposition film, since water vapor reacts with aluminum to increase the degree of hydroxylation, it is desirable that the water vapor partial pressure is 0.001 Pa or less.

At the same time, as the application of the above barrier film, the development of backlight members using a quantum dot technology is also progressing. Quantum dots are nanometer-sized particles of a semiconductor. The emission wavelength of a quantum dot can be adjusted across the entire visible region by adjusting the size through a quantum confinement effect (quantum size effect) in which electrons or excitons are confined within small nanometer-sized crystals. The quantum dot is a fluorescent substance that can emit strong fluorescence in a narrow wavelength range, which will enable a display device to illuminate with light of three primary colors with excellent color purity. Accordingly, a display device can have excellent color reproducibility by a backlight using quantum dots.

The wavelength conversion sheet that is used in the backlight source of this display device has a structure in which a fluorescent substance layer obtained by dispersing nanometer-sized particles of a semiconductor in a resin layer is laminated with a barrier film on both surfaces thereof for suppressing deterioration of the fluorescent substance layer and is combined with an LED light source.

For example, a wavelength conversion sheet in which a barrier film is laminated to a fluorescent substance layer containing a fluorescent substance, wherein the wavelength conversion sheet includes a barrier film obtained by laminating a barrier layer to one surface of a specified polyethylene terephthalate film, and a backlight unit including the wavelength conversion sheet have been developed (Patent Document 3). The wavelength conversion sheet including a barrier film having excellent barrier property and transparency can provide a display device exhibiting more natural and clear colors and excellent color tone.

Citation List

Patent Documents

Patent Document 1: Japanese Unexamined Patent Application, Publication No. 2017-177343
Patent Document 2: Japanese Unexamined Patent Application, Publication No. 2022-052319
Patent Document 3: WO2015/037733

DISCLOSURE OF THE INVENTION

Problems to be Solved by the Invention

In Patent Document 1, the reactivity between oxygen and aluminum is enhanced by plasma assist at the time of vapor deposition, and improvements in the transparency and barrier properties are recognized. However, there is a problem that color irregularity is likely to occur in the barrier film and is conspicuous. Regardless of the presence or absence of plasma assistance, when reactive vapor deposition is performed, in general, the uniform appearance is maintained by keeping the transmittance in a certain range through feedback of the amount of evaporated aluminum or introduced amount of oxygen by measuring the transmittance after vapor deposition. However, when production is performed at a high rate of several hundred meters per minute, this feedback control may not respond in time. Consequently, if a film is formed with a variation in the transmittance, color irregularity is caused, and the appearance viewed from an end surface of a barrier film wound body becomes Baumkuchen-like. Its appearance suggests that the quality is not uniform, which becomes a problem. Formation of a film with high transparency and barrier properties by plasma assistance has problems of notable color irregularity and a difficulty in acquired reduction in the color irregularity.

In addition, as described in Patent Document 2, in the vapor deposition process of aluminum oxide, for example, it is usually performed to reduce the moisture in a vapor deposition chamber using a cold trap, cryopump, or the like.

In a wavelength conversion sheet as shown in Patent Document 3, the oxygen and water vapor barrier properties of the barrier film are required to be further improved in order to suppress the deterioration of the fluorescent substance layer. In particular, the luminance of a wavelength conversion sheet decreases over time by the deterioration of the fluorescent substance layer. Consequently, in order to maintain the luminance as a wavelength conversion sheet for a long time, a particularly high barrier property is required.

It is an object of the present invention to provide a barrier film including an aluminum oxide deposition film, having reduced color irregularity, and exhibiting high luminance retention rate when used in a wavelength conversion sheet.

Means for Solving the Problems

The present inventors have intensively studied to solve the above problems and, as a result, have found by focusing on the amount of hydroxyl groups in an aluminum oxide thin film obtained by X-ray absorption fine structure analysis (hereinafter, simply referred to as XAFS) that when a barrier film is used in a wavelength conversion sheet, the luminance retention rate can be increased and at the same time, the color irregularity of the barrier film can be reduced, and the present invention has been accomplished.

Specifically, the present invention provides the following.

(1) A barrier film comprising a resin base material, a first aluminum oxide deposition film, a first covering layer, a second aluminum oxide deposition film, and a second covering layer laminated in this order, wherein

the first covering layer and the second covering layer are each a cured product of a resin composition containing an alkoxysilane and a hydroxyl group-containing water-soluble resin, and

the first aluminum oxide deposition film and the second aluminum oxide deposition film each have a deposition film peak top ratio P of 1.05 or more and 1.60 or less defined by the following equation when X-ray absorption fine structure analysis is performed from the surface side of the second covering layer of the barrier film:

P = (intensity peak top at around 1,572 eV) / (intensity peak top at around 1,566 eV).

(2) The barrier film according to (1), wherein when the barrier film is etched from the surface side opposite to the resin base material by time-of-flight secondary ion mass spectrometry (TOF-SIMS), a covering layer intensity ratio X defined by an equation below, where the intensity is detected in each of regions of the first covering layer and the second covering layer, is 0.50 or more and 1.10 or less:

$$X = C_2^- \text{ ion intensity} / Si^- \text{ ion intensity}.$$

(3) The barrier film according to (1), wherein a matte layer is disposed on the resin base material on the side opposite to the first aluminum oxide deposition film.

(4) A laminate comprising the barrier film according to (1) and a support laminated with a sticky adhesive layer therebetween.

(5) The laminate according to (4), wherein a matte layer is disposed on the support on the side opposite to the sticky layer.

(6) A wavelength conversion sheet comprising the barrier films according to (3) and a fluorescent substance layer disposed therebetween.

(7) A wavelength conversion sheet comprising the laminates according to (4) and a fluorescent substance layer disposed therebetween, wherein the laminates are each disposed such that the support, the resin base material, the covering layer, and the fluorescent substance layer are arranged in this order from the outermost layer side.

(8) A wavelength conversion sheet comprising the laminates according to (4) and a fluorescent substance layer disposed therebetween, wherein the laminates are each disposed such that the support, the covering layer, the resin base material, and the fluorescent substance layer are arranged in this order from the outermost layer side.

(9) A wavelength conversion sheet comprising the laminates according to (4) and a fluorescent substance layer disposed therebetween, wherein one of the laminates is disposed such that the support, the resin base material, the covering layer, and the fluorescent substance layer are arranged in this order from the outermost layer side, and the other laminate is disposed such that the support, the covering layer, the resin base material, and the fluorescent substance layer are arranged in this order from the outermost layer side.

(10) A backlight member comprising a light source, a light guide plate or light diffusion plate, and the wavelength conversion sheet according to (6).

(11) A surface-mounted display device comprising a light guide plate,

wherein a liquid crystal panel, a polarization-selective reflection sheet, a prism sheet, the wavelength conversion sheet according to (6), the light guide plate, and a reflection sheet are sequentially laminated, and a light source section is disposed on an end surface of the light guide plate.

(12) A direct-type display device comprising a light diffusion plate,

wherein a liquid crystal panel, a polarization-selective reflection sheet, a prism sheet, the wavelength conversion sheet according to (6), the light diffusion plate, a light source section, and a reflection sheet are sequentially laminated.

Effects of the Invention

The barrier film of the present invention when used in a wavelength conversion sheet can simultaneously increase the luminance retention rate and reduce color irregularity of the barrier film.

BRIEF DESCRIPTION OF THE DRAWINGS

Fig. 1 is a cross-sectional view illustrating an example of the barrier film according to the present embodiment;

Fig. 2 is a diagram illustrating an example of the film-forming apparatus according to an embodiment of the present invention;

Fig. 3 is a cross-sectional view illustrating an example of the plasma pretreatment mechanism of the film-forming apparatus;

Fig. 4 is a plan view illustrating an example of an electrode section and a magnetic field-forming section of the plasma pretreatment mechanism of the film-forming apparatus;

Fig. 5 is a cross-sectional view illustrating an example of the electrode section and the magnetic field-forming section of the plasma pretreatment mechanism of the film-forming apparatus;

Fig. 6 is a cross-sectional view illustrating an example of the film-forming mechanism of the film-forming apparatus;

Fig. 7 is a cross-sectional view illustrating an example of the laminate including the barrier film of the present invention;

Fig. 8 is a cross-sectional view illustrating another example of the laminate including the barrier film of the present invention;

Fig. 9 is a cross-sectional view illustrating another example of the laminate including the barrier film of the present invention;

Fig. 10 is a cross-sectional view illustrating an example of the wavelength conversion sheet including the barrier film of the present invention;

Fig. 11 is a cross-sectional view illustrating another example of the wavelength conversion sheet including the barrier film of the present invention;

Fig. 12 is a perspective view schematically showing a structure of the surface-mounted display device according to an embodiment of the present invention;

Fig. 13 is a cross-sectional view of the display device shown in Fig. 10;

Fig. 14 is a cross-sectional view schematically showing a structure of the direct-type display device according to an embodiment of the present invention;

Fig. 15 is a graph showing an XAFS spectrum of the barrier film of Example 2;

Fig. 16 is a graph showing the results of XAFS spectral analysis of the barrier film of Example 2;

Fig. 17 is a graph showing the results of XAFS spectral analysis of the barrier film of Comparative Example 2;

Fig. 18 is a graph showing the results of XAFS spectral analysis of the barrier film of Comparative Example 4;

Fig. 19 is a graph showing the results of XAFS spectral analysis of the barrier film of Comparative Example 8;

Fig. 20 is a graph showing the TOF-SIMS spectral results of the barrier film of Example 2;

Fig. 21 is a graph showing the TOF-SIMS spectral results of the barrier film of Example 3; and

Fig. 22 is a graph showing the TOF-SIMS spectral results of the barrier film of Comparative Example 8.

PREFERRED MODE FOR CARRYING OUT THE INVENTION

Specific embodiments of the present invention will now be described in detail, but the present invention is not limited to the following embodiments in any way and can be implemented with appropriate modifications within the scope of the purpose of the present invention. In the present specification, the notation "A to B" (A and B are arbitrary numbers) means "AX or more and B or less".

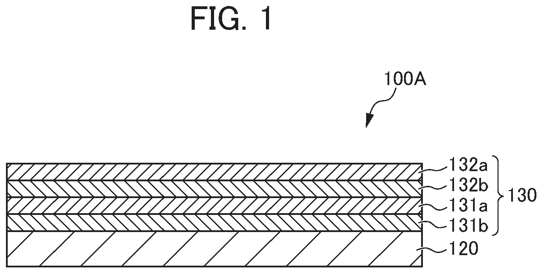

Fig. 1 is a cross-sectional view illustrating an example of the barrier film according to the present embodiment. The barrier film manufactured using the film-forming apparatus according to the present embodiment includes, for example, as in the barrier film 100A shown in Fig. 1, a base material 120, a first deposition film 131b, a first covering layer 131a, a second deposition film 132b, and a second covering layer 132a. In the example shown in Fig. 1, the first deposition film 131b is located on one surface of the base material 120. In the example shown in Fig. 1, the barrier film 100A is composed of the base material 120, the first deposition film 131b, the first covering layer 131a, the second deposition film 132b, and the second covering layer 132a laminated sequentially, and the second covering layer 132a is located on the surface of the barrier film. The first deposition film 131b, the first covering layer 131a, the second deposition film 132b, and the second covering layer 132a constitute the barrier layer 130. The first aluminum oxide deposition film and the second aluminum oxide deposition film in the present invention will now be described simply as a first deposition film and a second deposition film, respectively.

In the present specification, "lamination in this order" means that a base material, a deposition film, and a covering layer are laminated merely in this order, and other layers, such as an anchor coat layer and a primer layer, may be laminated between these layers.

Each layer constituting the barrier film 100A will be described below.

[Base material]

The base material 120 is a layer made of a resin. The resin is not particularly limited, and a known resin film or sheet can be used. Specifically, a polyester base material or a polyolefin base material may be used. As the polyester base material, for example, a polyester resin, such as a polyethylene terephthalate resin, a polybutylene terephthalate resin, and a polyethylene naphthalate resin, can be used. As the polyolefin base material, for example, a polypropylene resin can be used.

Among polyester resins, a polyethylene terephthalate resin and a polybutylene terephthalate resin are preferably used. The polyester film that is used as the base material 120 may be oriented in a predetermined direction. In such a case, the polyester film may be a uniaxially oriented film oriented in a predetermined direction or may be a biaxially oriented film oriented in predetermined two directions. For example, when a film made of polyethylene terephthalate is used as the base material 1, a biaxially oriented polyethylene terephthalate film can be used.

When a film made of a polypropylene resin is used as the base material 120, a biaxially oriented polypropylene film can be used.

The film thickness of the polyester film is not particularly restricted, as long as the pre-treatment and film formation treatment for forming a deposition film 2 with a film-forming apparatus described later are acceptable. From the viewpoint of flexibility and shape retention property, the film thickness is preferably in a range of 5 μm or more and 100 μm or less and more preferably in a range of 10 μm or more and 50 μm or less. When the thickness of the polyester film is within the above range, the film is easy to bend and also will not tear during transportation, and is easily handled with a film-forming apparatus that is used for manufacturing a barrier film including the deposition film 2 having improved adhesion.

As the polyethylene terephthalate film (PET film) to be used as the base material, in addition to a conventionally known PET film, a biomass PET film, a recycle PET film, and a high stiffness PET film (tough PET film) may be used. The base material may be a single layer or have a multi-layer structure of two or more layers. The multi-layer may be of the same composition or of different compositions. In the multi-layer structure, the layers may be bonded with an adhesive layer or the like.

The film thickness of the polyolefin film is preferably in a range of 10 μm or more and 100 μm or less and more preferably in a range of 15 μm or more and 50 μm or less from the viewpoint of the flexibility and shape retention property.

The base material 120 may be provided with an anchor coat layer (also referred to as AC layer or primer layer) formed on its surface for enhancing the adhesion with the deposition film. Examples of the anchor coat layer are a polyurethane resin, a polyamide resin, an epoxy resin, a phenolic resin, a (meth)acrylic resin, and a polyvinyl acetate resin. Examples of the polyurethane resin are an acrylic urethane resin and a polyester urethane resin.

The base material 120 of a wound body is preferably humidified in advance by a manufacturing process or humidity control process. Consequently, the barrier properties can be improved. In addition, base material breakage during plasma-assisted deposition described later can be prevented. As an example, humidity control condition is to store at a temperature of 22°C to 30°C and a relative humidity of 40% to 65% RH for 1 to 7 days. It is also effective to rewind the wound body in advance before storage for humidity control. In such a case, it is also preferable to perform the rewinding process under the above humidity control conditions.

[Deposition film]

Then, the first deposition film 131b and the second deposition film 132b (hereinafter, both are also simply referred to as deposition film without distinction) will be described. The deposition film contains aluminum oxide. Aluminum is at least partially present in a state of $Al_2O_3$ formed in the deposition film. The deposition film may further contain silicon oxide, silicon nitride, silicon oxynitride, silicon carbide, or another metal oxide such as magnesium oxide, titanium oxide, tin oxide, indium oxide, zinc oxide, and zirconium oxide, or a nitride or carbide of these metals. The first deposition film 131b and the second deposition film 132b may be the same or different.

The lower limit of the thickness of the deposition film is preferably 3 nm or more and more preferably 5 nm or more. The upper limit is preferably 100 nm or less, more preferably 50 nm or less, and particularly preferably 15 nm or less. The first deposition film 131b and the second deposition film 132b may be the same or different.

The "aluminum oxide deposition film" in the present invention means a "deposition film containing aluminum oxide" as described above, and may include, in addition to aluminum oxide $Al_2O_3$, aluminum hydroxide oxide $AlO(OH)$, aluminum hydroxide $Al(OH)_3$, and so on. The details will now be described.

(XAFS spectral analysis)

XAFS analysis obtains an X-ray absorption fine structure (XAFS) spectrum by irradiating X-rays from the surface side of the deposition surface of the barrier film (when a covering layer is present, from the covering layer side) and measuring the amount of absorption. The details of the measurement conditions and analysis conditions will be described in Examples.

In particular, the XAFS spectral analysis with soft X-rays using synchrotron radiation can obtain bulk information on the entire deposition film, not partial information on the deposition film surface side, and can obtain information on the size of hydroxyl groups in the aluminum oxide deposition film. Even when a covering layer or the like is present on the surface of the deposition film, it is possible to obtain information on the deposition film with the covering layer present by irradiating the deposition film from the covering layer surface side through the covering layer. As in the structure shown in Fig. 1, when the first deposition film 131b and the second deposition film 132b are provided, the XAFS spectrum of the bulk is obtained with the two deposition films combined.

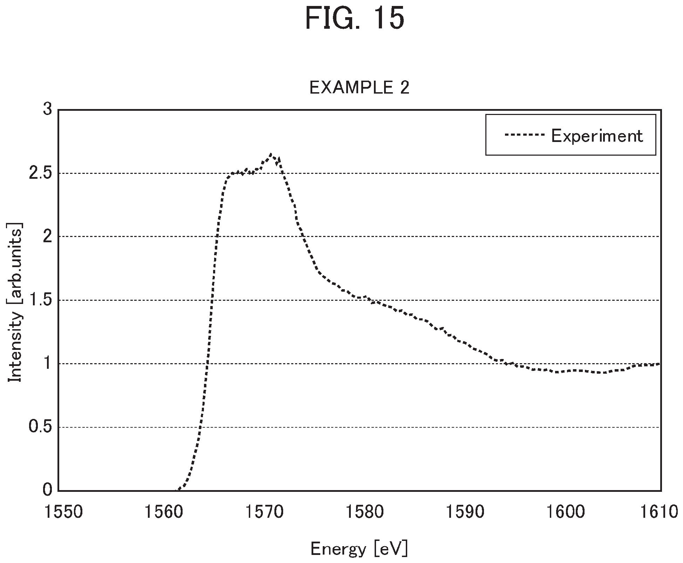

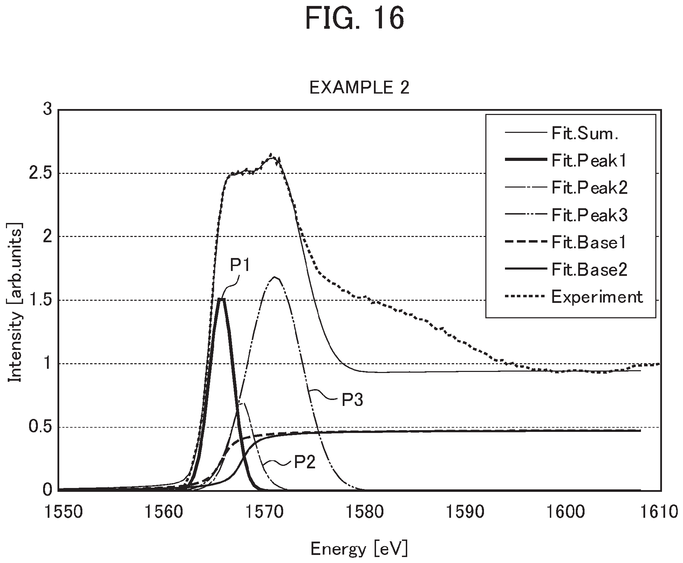

Fig. 15 is an example of the results of XAFS measurement of an example of the barrier film in Examples described later. Fig. 16 displays peaks obtained by peak separation of the XAFS spectrum in Example 2. In Figs. 15 and 16, the vertical axis represents absorption intensity (a.u.), and the horizontal axis represents energy (eV). The deposition film peak top ratio P in the present invention is, for example, as shown in Fig. 16, the ratio determined from each peak top after the peak separation of an XAFS spectrum.

In the peak separation analysis of Fig. 16, Experiment is an actually measured XAFS spectrum, Fit. Peak 1 is a separated intensity peak at 1,566 eV, Fit. Peak 2 is a separated intensity peak at 1,568 eV, and Fit. Peak 3 is a separated intensity peak at 1,572 eV. Fit. Base 1 is the base line of 1,566 eV, and Fit. Base 2 is the base line of 1,568 eV.

As shown in Figs. 15 and 16, an XAFS spectrum includes multiple peaks, specifically, a peak P1 with a top around 1,566 eV, a peak P2 with a top around 1,568 eV, and a peak P3 with a top around 1,572 eV. Around 1,566 eV is 1,565 eV or more and 1,567 eV or less, around 1,568 eV is greater than 1,567 eV and 1,569 eV or less, and around 1,572 eV is 1,571 eV or more and 1,573 eV or less.

Here, it is believed that P1 is a peak derived from tetra-coordinated aluminum oxide, P2 is a peak derived from hexa-coordinated aluminum oxide, and P3 is a peak derived from hexa-coordinated aluminum hydroxide and aluminum hydroxide oxide.

Since it is believed that the flexibility of an aluminum oxide film is more excellent in an amorphous form than in a crystal form, an amorphous aluminum oxide film is preferable when used in the barrier film. However, it is difficult to verify whether an aluminum oxide film is crystal or amorphous, except when a clear crystal peak can be confirmed by XRD which is a conventional X-ray analysis.

When an XAFS spectrum is confirmed, if a peak P1 is detected in a crystal aluminum oxide film, the crystal aluminum oxide is $\gamma$-$Al_2O_3$ or $\theta$-$Al_2O_3$, but the peak P1 is not relatively higher than the peak P2. According to Examples described later of the present application, for example, as in Example 2 (see Fig. 15), it is clear that P1 > P2, and it is confirmed that an amorphous film is formed.

Furthermore, in order to withstand a luminance retention rate test (which will be described in Examples later) when the aluminum oxide film is used in a wavelength conversion sheet, the condition of being amorphous is not enough, and it is believed that introduction of a hydroxyl group is necessary. However, for example, in depth analysis using conventional TOF-SIMS, correlation between the film formation condition and the film quality cannot be sufficiently investigated due to the fact that it is unclear whether the aluminum oxide film is evaluated or moisture remaining in the interface between the aluminum oxide film and the base material is detected and the fact that when a covering layer is present, sufficient depth resolution is not obtained in a portion of the aluminum oxide film.

According to the present invention, an XAFS spectrum is verified to define a deposition film peak top ratio P = P3 peak top / P1 peak top = (intensity peak top at around 1,572 eV) / (intensity peak top at around 1,566 eV), and thereby it is possible to also obtain information on the amount of hydroxyl groups in an aluminum oxide deposition film.

The present inventors found that in order to reduce the color irregularity, a method in which an aluminum oxide film is formed in a state of including a large number of dangling bonds and having a low water vapor barrier property and the number of the dangling bonds is reduced by promoting oxidation and hydroxylation (mainly hydroxylation) through aging to express a water vapor barrier property is effective, compared to forming a film in a state of a high water vapor barrier property from immediately after vapor deposition. Accordingly, correlation between the film formation conditions including moisture at the time of vapor deposition, aging, and so on and the film quality was investigated by verifying XAFS spectra, and the present invention has been accomplished.

The present invention is accomplished by finding that the discoloration of a barrier film changes depending on the value of this deposition film peak top ratio P. Specifically, improvement in the barrier property and reduction in the color irregularity of the barrier film can be simultaneously achieved by adjusting the deposition film peak top ratio P to 1.05 or more and 1.60 or less. The lower limit of the deposition film peak top ratio P is preferably 1.06 or more, more preferably 1.09 or more, and particularly preferably 1.20 or more. The upper limit of the peak top ratio P is preferably 1.54 or less and more preferably 1.40 or less.

If the deposition film peak top ratio P is less than 1.05, color irregularity is conspicuous due to the high oxide film immediately after vapor deposition, and discoloration hardly occurs due to the high barrier property. The "discoloration" means that the transparency (transmittance) is improved by the changes over time after vapor deposition or that the color becomes lighter. This transparency or color affects the appearance of the end surface portion (side surface portion) of a wound form. The detail will be described in evaluation of "color irregularity" in Examples. If the peak top ratio P is greater than 1.60 by performing heat-moisture treatment at high temperature and high humidity or the like, the introduction of hydroxyl groups is too large, and the initial barrier properties, particularly, the water vapor barrier property decreases.

In the present invention, in order to improve the "color irregularity", the luminance retention rate is slightly decreased for improving the color irregularity. Specifically, the color irregularity can be improved by intentionally adjusting the luminance retention rate in Examples described later to about 90% to 94%, not 95% or more. The luminance retention rate qualitatively correlates to barrier properties, but since the environment for testing the luminance retention rate is severe: leaving to stand in a thermos-hygrostat of 60°C and 90% RH for 1,000 hours, even when there is no difference in oxygen and water vapor barrier properties near the measurement limit, a difference occurs in the luminance retention rate.

The deposition film peak top ratio P in a barrier film can be adjusted by controlling the combination of plasma pretreatment, plasma-assisted treatment at the time of vapor deposition, use or not use of cold trap in a film-forming process, aging treatment after a film-forming process, and aging treatment after a covering layer-forming process. In particular, improvement in the luminance retention rate when the barrier film is used in a wavelength conversion sheet and improvement in the color irregularity of the barrier film can be simultaneously achieved by not using cold trap in a film-forming process. These results will be described in detail in description of manufacturing method and Examples later.

(Covering layer)

The first covering layer 131a laminated on the surface of the first aluminum oxide deposition film 131b and the second covering layer 132a laminated on the surface of the second aluminum oxide deposition film 132b mechanically and chemically protect the aluminum oxide deposition films and improve the barrier property performance of the laminated film having barrier properties. Hereinafter, the first covering layer 131a and the second covering layer 132a (hereinafter, both are also simply referred to as the covering layer without distinction) to be coated for forming barrier laminated films will be described. In the following description, the materials, compositions, film thicknesses, and so on of the first covering layer 131a and the second covering layer 132a may be the same or different.

The covering layer is formed by applying the barrier coating agent onto an aluminum oxide deposition film and solidifying it. The barrier coating agent is composed of a metal alkoxide, a water-soluble polymer, and as needed, a silane coupling agent, a sol-gel method catalyst, an acid, and so on.

As the metal alkoxide, at least one metal alkoxide represented by a formula: $R^1{}_nM(OR^2)_m$ (wherein, R1 and R2 each independently represent an organic group having 1 to 8 carbon atoms, M represents a metal atom, n represents an integer of 0 or more, m represents an integer of 1 or more, and n + m represents the valency of M) is preferable. Examples of the metal atom represented by M of the metal alkoxide include silicon, zirconium, titanium, aluminum, and the like. For example, it is preferable to use an alkoxysilane with Si as M.

The above-mentioned alkoxysilane is represented by, for example, a formula: $Si(ORa)_4$ (wherein, Ra represents a lower alkyl group). In the above, as the Ra, a methyl group, an ethyl group, an n-propyl group, an n-butyl group, and so on are used. Specific examples of such an alkoxysilane include tetramethoxysilane $Si(OCH_3)_4$, tetraethoxysilane

$Si(OC_2H_5)_4$, tetrapropoxysilane $Si(OC_3H_7)_4$, tetrabutoxysilane $Si(OC_4H_9)_4$, and the like. The above alkoxides may be used in combination of two or more.

As the silane coupling agent, those having a reactive group such as a vinyl group, an epoxy group, a methacrylic group, and an amino group can be used. In particular, an organoalkoxysilane including an epoxy group is preferable. For example, γ-glycidoxypropyltrimethoxysilane, γ-glycidoxypropylmethyldimethoxysilane, γ-glycidoxypropyldimethylmethoxysilane, γ-glycidoxypropyltriethoxysilane, γ-glycidoxypropylmethyldiethoxysilane, γ-glycidoxypropyldimethylethoxysilane, or β-(3,4-epoxycyclohexyl)ethyltrimethoxysilane can be used. The above-mentioned silane coupling agents may be used alone or as a mixture of two or more.

In particular, the crosslinking density of a cured film of a covering layer made of a bifunctional compound such as γ-glycidoxypropylmethyldimethoxysilane and γ-glycidoxypropylmethyldiethoxysilane is lower than the crosslinking density of a system using a trialkoxysilane. Accordingly, the cured film has flexibility and also excellent elasticity while having excellent gas barrier property and hot water treatment resistance as a film, and therefore the gas barrier property of the barrier film is hardly deteriorated.

As the water-soluble polymer, a polyvinyl alcohol resin or an ethylene-vinyl alcohol copolymer can be used alone. Alternatively, a polyvinyl alcohol resin and an ethylene-vinyl alcohol copolymer can be used in combination. In the covering layer according to the present embodiment, a polyvinyl alcohol resin is preferable.

As the polyvinyl alcohol resin, generally, those obtained by saponification of polyvinyl acetate can be used. The polyvinyl alcohol resin may be a partially saponified polyvinyl alcohol resin with several tens of percent of acetate groups remaining, a completely saponified polyvinyl alcohol with no acetate groups remaining, or a modified polyvinyl alcohol resin with modified OH-groups. The polyvinyl alcohol resin is required to have a saponification degree of at least allowing crystallization that improves the hardness of the gas barrier coating film, and the saponification degree is preferably 70% or more. In addition, the polyvinyl alcohol resin with the polymerization degree within a range (about 100 to 5,000) that is used in a conventional sol-gel method can be used. Examples of such a polyvinyl alcohol resin include an RS resin "RS-110 (saponification degree: 99%, polymerization degree: 1,000) manufactured by Kuraray Co., Ltd., "Gohsenol NM-14 (saponification degree: 99%, polymerization degree: 1,400)" manufactured by The Nippon Synthetic Chemical Industry Co., Ltd., and the like.

As the ethylene-vinyl alcohol copolymer, a saponification product of a copolymer of ethylene and vinyl acetate, that is, a product obtained by saponifying an ethylene-vinyl acetate random copolymer can be used. For example, the saponification products include from a partially saponified product with several tens of mole percent of acetate groups remaining to a completely saponified product with several mole percent of acetate groups or no acetate groups remaining, and are not particularly limited. However, from the viewpoint of the barrier properties, the lower limit of the saponification degree is preferably 80% or more, more preferably 90% or more, and further preferably 95% or more. The upper limit is 100% or less.

The sol-gel method catalyst is suitably an acid or amine compound.

As the acid, for example, mineral acids such as sulfuric acid, hydrochloric acid, and nitric acid and organic acids such as acetic acid and tartaric acid can be used.

The content of the acid is preferably 0.001 to 0.05 mol%, more preferably 0.01 to 0.03 mol%, based on the total molar amount of the alkoxy group of the metal alkoxide. If the content is less than 0.001 mol%, the catalytic effect is too small. If the content is greater than 0.05 mol%, the catalytic effect is too strong, and the reaction rate becomes too fast, which may make the reaction uneven.

As the amine compound, a tertiary amine that is substantially insoluble in water and soluble in an organic solvent is suitable. Specifically, for example, N,N-dimethylbenzylamine, tripropylamine, tributylamine, and tripentylamine can be used. In particular, N,N-dimethylbenzylamine is suitable.

The content of the amine compound is, for example, preferably 0.01 to 1.0 parts by mass, particularly 0.03 to 0.3 parts by mass, based on 100 parts by mass of the metal alkoxide. If the content is less than 0.01 parts by mass, the catalytic effect is too small, and if the content is greater than 1.0 parts by mass, the catalytic effect is too strong, and the reaction rate becomes too fast, which may make the reaction uneven.

As the solvent, water and alcohols such as methyl alcohol, ethyl alcohol, n-propyl alcohol, isopropanol, and n-butanol can be preferably used.

The barrier covering layer formed as described above has a thickness of 100 to 500 nm. This range is preferable, because the coating film is not broken and can sufficiently cover the deposition film surface.

As the composition of the barrier coating agent, the water-soluble polymer such as a polyvinyl alcohol resin and the silane coupling agent can be used in ranges of 5 to 20 parts by mass and 0 to 10 parts by mass, respectively, based on 100 parts by mass of the alkoxysilane. Consequently, the flexibility of the film can be maintained. In the above, it is not preferable to use the silane coupling agent in an amount exceeding 20 parts by mass, because the rigidity and brittleness of the formed barrier coating film are increased.

The lower limit of the IO value (solid content ratio of a metal alkoxide ($SiO_2$ equivalent) such as tetraethoxysilane to a water-soluble resin such as polyvinyl alcohol) in the covering layer is preferably 1.5 or more and more preferably 1.9 or more. The upper limit is preferably 4.5 or less and more preferably 3.5 or less. An IO value exceeding 4.5 is not preferable, because the flexibility is lost from the covering layer and a crack is likely to occur, which decreases the barrier properties. An IO value less than 1.5 is not preferable, because the condensation of the hydrolysate generated from the metal alkoxide does not sufficiently progress, and the heat-moisture resistance decreases.

($C_2$/Si ratio analysis by TOF-SIMS)

When the covering layer is etched from the surface side opposite to the resin base material of the barrier film by time-of-flight secondary ion mass spectrometry (TOF-SIMS), the covering layer intensity ratio X, which is defined by the following equation and detected in each of the regions of the first covering layer and the second covering layer, is 0.50 or more and 1.10 or less:

$$X = C_2^- \text{ ion intensity } / \text{ Si}^- \text{ ion intensity.}$$

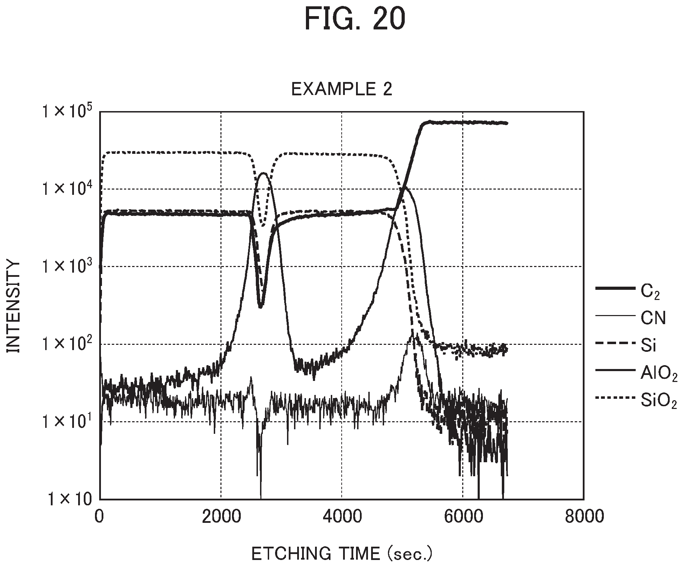

The covering layer intensity ratio X of the covering layer of the barrier film according to the present embodiment will be described using Example 2 (Fig. 20) described later. Fig. 20 is an example of a graph analysis chart showing the detection intensity of secondary ions that reflect the element types contained in the barrier film and the chemical structure information measured by etching (analysis in the depth direction) the barrier film of Example 2 having the layer structure of Fig. 1 from the surface side of the second covering layer 132a (surface side opposite to the base material) by time-of-flight secondary ion mass spectrometry (TOF-SIMS). The unit of the vertical axis of the graph is the intensity of detected secondary ions, expressed as common logarithm. The unit (Et times) of the horizontal axis of the graph is the etching time (sec).

TOF-SIMS (time-of-flight secondary ion mass spectrometry) is a method of mass analysis in which the surface of a solid sample to be analyzed is irradiated with a pulsed primary ion beam, and the secondary ions emitted by sputtering the sample surface are mass-separated using differences in their flight times (flight time is proportional to the square root of the mass).

When the depth direction is analyzed, specifically, when the second covering layer 132a and the first covering layer 131a are analyzed using a time-of-flight secondary ion mass spectrometer while repeating soft-etching at a constant rate with a Cs (cesium) ion gun from the outermost surface of the second covering layer 132a, the respective graphs of the detection intensity of the secondary ions that reflect the element types and the chemical structure information are obtained. Specifically, as shown in Fig. 20, as ion intensity, $C_2^-$ ion, $CN^-$ ion, $Si^-$ ion, $AlO_2^-$ ion, $SiO_2^-$ ion intensities are detected to obtain a graph. Depending on the etching time, from the surface side, $C_2^-$ ion intensity and $Si^-$ ion intensity derived from the second covering layer 132a, $AlO_2^-$ ion intensity derived from the second deposition film 132b, $C_2^-$ ion intensity and $Si^-$ ion intensity derived from the first covering layer 131a, $AlO_2^-$ ion intensity derived from the first deposition film 131b, and $C_2^-$ ion intensity derived from the PET are observed in order.

In the barrier film of the present invention, the covering layer intensity ratio X detected in each of the regions of the first covering layer 131a and the second covering layer 132a and defined below is 0.50 or more and 1.10 or less:

$$X = C_2^- \text{ ion intensity } / \text{ Si}^- \text{ ion intensity}$$

Here, covering layer intensity ratio X is the average of the respective covering layer regions. In Fig. 20, as an example, the ratio X is calculated by defining that the region of the second covering layer 132a is from 500 to 2,000 seconds and the region of the first covering layer 131a is from 3,300 to 4,500 seconds. The detail of the measurement conditions of TOF-SIMS are the conditions described in Examples.

A covering layer intensity ratio X of less than 0.50 is not preferable, because the flexibility is lost from the covering layer and a crack is likely to occur, which decreases the barrier properties. A covering layer intensity ratio X of greater than 1.10 is not preferable, because the Si concentration is low, which decreases the heat-moisture resistance.

(Film-forming apparatus)

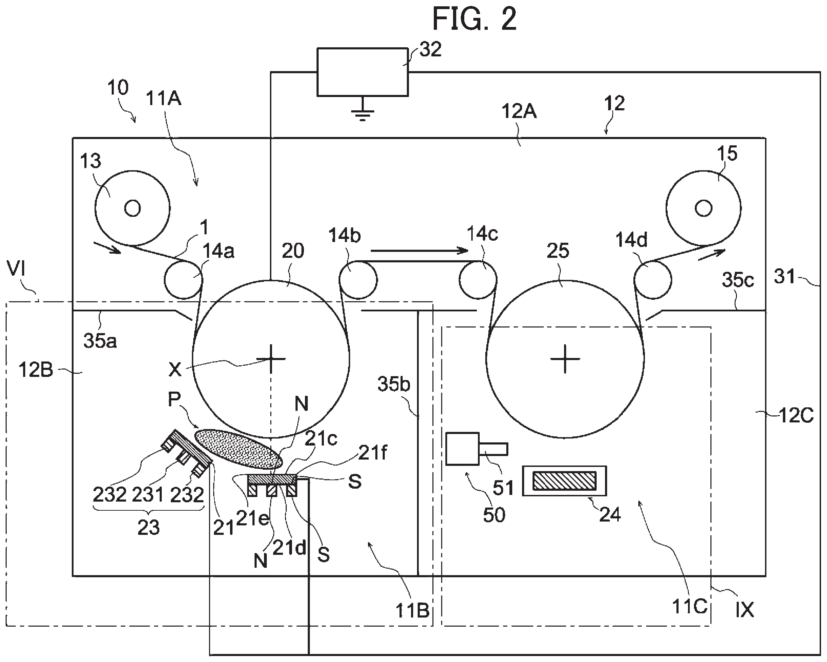

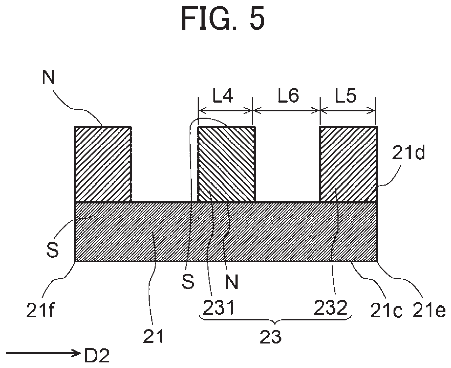

Then, an example of the film-forming apparatus 10 that is used in the method for manufacturing the barrier film will now be described. The film-forming apparatus 10 includes, as shown in Fig. 2, a base material-transporting mechanism 11A for transporting a base material 1 (corresponding to the above-described base material 120), a plasma pretreatment mechanism 11B for performing plasma pretreatment of the surface of the base material 1, and a film-forming mechanism 11C for forming a deposition film 2. In the example shown in Fig. 5, the film-forming apparatus 10 further includes a decompression chamber 12. The decompression chamber 12 has a pressure-reducing mechanism for adjusting the atmosphere in at least a part of the internal space of the decompression chamber 12, such as a vacuum pump described later, to the atmospheric pressure or less.

In the example shown in Fig. 2, the decompression chamber 12 includes a base material transport room 12A in which the base material-transporting mechanism 11A is located, a plasma pretreatment room 12B in which the plasma pretreatment mechanism 11B is located, and a film-forming room 12C in which the film-forming mechanism 11C is located. The decompression chamber 12 is preferably configured to prevent the atmosphere inside each of the rooms from mixing with each other. For example, as shown in Fig. 2, the decompression chamber 12 may include partition walls 35a to 35c separating each room between the base material transport room 12A and the plasma pretreatment room 12B, between the plasma pretreatment room 12B and the film-forming room 12C, and between the base material transport room 12A and the film-forming room 12C.

The base material transport room 12A, the plasma pretreatment room 12B, and the film-forming room 12C will be described. The plasma pretreatment room 12B and the film-forming room 12C are each disposed so as to be in contact with the base material transport room 12A and each have a portion being connected to the base material transport room 12A. Consequently, a base material 1 can be transported between the base material transport room 12A and the plasma pretreatment room 12B and between the base material transport room 12A and the film-forming room 12C without being exposed to the atmosphere. For example, the base material 1 can be transported between the base material transport room 12A and the plasma pretreatment room 12B through an opening provided in the partition wall 35a. The structure between the base material transport room 12A and the film-forming room 12C is the same, and the base material 1 can be transported between the base material transport room 12A and the film-forming room 12C.

The function of the pressure-reducing mechanism of the decompression chamber 12 will be described. The pressure-reducing mechanism of the decompression chamber 12 is configured such that the atmosphere of the space where at least the plasma pretreatment mechanism 11B or the film-forming mechanism 11C of the film-forming apparatus 10 is arranged can be reduced to the atmospheric pressure or less. The pressure-reducing mechanism may be configured such that the pressures in the base material transport room 12A, the plasma pretreatment room 12B, and the film-forming room 12C partitioned by the partition walls 35a to 35c can be each reduced to the atmospheric pressure or less.

The configuration of the pressure-reducing mechanism of the decompression chamber 12 will be described. The decompression chamber 12 may include, for example, a vacuum pump that is connected to the plasma pretreatment room 12B. The pressure in the plasma pretreatment room 12B when the plasma treatment described later is implemented can be appropriately controlled by adjusting the vacuum pump. The plasma supplied in the plasma pretreatment room 12B can be suppressed from diffusing to another room by a method described later. The pressure-reducing mechanism of the decompression chamber 12 may have a vacuum pump connected to the film-forming room 12C, similar to the vacuum pump connected to the plasma pretreatment room 12B. As the vacuum pump, a dry pump, a turbomolecular pump, a cryopump, a rotary pump, a diffusion pump, or the like can be used.

The base material-transporting mechanism 11A of the base material 1 of the film-forming apparatus 10 according to the present embodiment will be described together with the transport route of the base material 1. The base material-transporting mechanism 11A is a mechanism for transporting the base material 1 and is arranged in the base material transport room 12A. In the example shown in Fig. 2, the base material-transporting mechanism 11A includes an unwinding roller 13 attached with the rolled original material of the base material 1, a winding roller 15 for winding the base material 1, and guide rollers 14a to 14d. The base material 1 sent from the base material-transporting mechanism 11A is then transported by a pretreatment roller 20 described later disposed in the plasma pretreatment room 12B and a film-forming roller 25 described later disposed in the film-forming room 12C.

The base material-transporting mechanism 11A may further include a tension pick-up roller (not shown in the figure). The base material-transporting mechanism 11A having a tension pick-up roller can transport the base material 1 while adjusting the tension applied to the base material 1.

(Plasma pretreatment mechanism)

The plasma pretreatment mechanism 11B will be described. The plasma pretreatment mechanism 11B is a mechanism for performing plasma pretreatment of the surface of the base material 1. The plasma pretreatment mechanism 11B shown in Fig. 2 generates plasma P and performing plasma pretreatment of the surface of the base material 1 using the generated plasma P. When the surface of the base material 1 is activated by the plasma pretreatment, for example, hydrogen is released from the base material resin component to generate carbon radicals. Subsequently, the carbon radicals bind to oxygen and hydrogen in the atmosphere to generate a functional group such as a hydroxyl group, a carboxyl group, and a ketone group. It is believed that the adhesion between the base material 1 and the deposition film 2 is improved by generating such a functional group. The plasma pretreatment mechanism 11B shown in Fig. 2 includes a pretreatment roller 20 disposed in the plasma pretreatment room 12B, an electrode section 21 facing the pretreatment roller 20, and a magnetic field-forming section 23 forming a magnetic field between the pretreatment roller 20 and the electrode section 21.

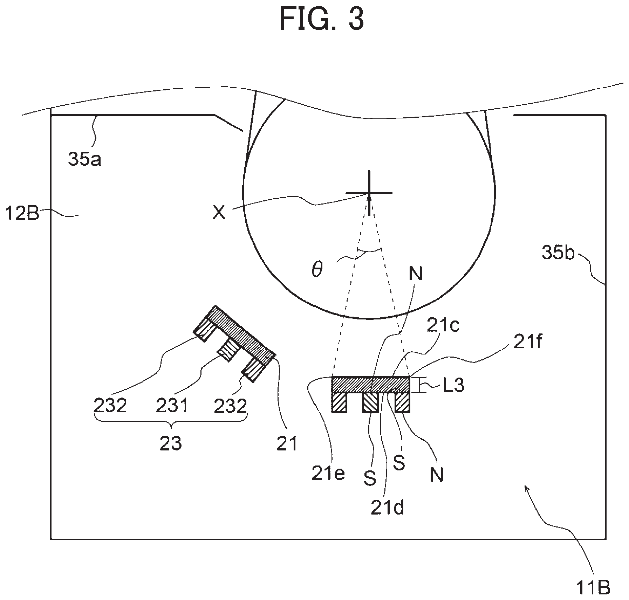

The pretreatment roller 20 will be described. Fig. 3 is an enlarged view of the part enclosed by the dashed line marked with the symbol VI in Fig. 2. In Fig. 3, a power supply wiring 31 connecting a power source 32 and an electrode section 21 described later and plasma P generated by the plasma pretreatment mechanism 11B, which are shown in Fig. 2, are omitted from drawing. The pretreatment roller 20 has a rotation axis X. The pretreatment roller 20 is disposed such that at least the rotation axis X is located in the plasma pretreatment room 12B partitioned by the partition walls 35a and 35b. The base material 1 having a dimension in the direction of the rotation axis X is wound on the pretreatment roller 20. In the following description, the dimension of the base material 1 in the direction of the rotation axis X is also referred to as the width of the base material 1. In addition, the direction of the rotation axis X is also referred to as the width direction of the base material 1.

As shown in Fig. 2, the pretreatment roller 20 may be disposed such that a part of the pretreatment roller 20 is exposed to the base material transport room 12A side. In the example shown in Fig. 2, the plasma pretreatment room 12B and the base material transport room 12A are connected to each other through an opening disposed in the partition wall 35a, and a part of the pretreatment roller 20 is exposed to the base material transport room 12A side through the opening. There is a gap between the partition wall 35a, which is disposed between the base material transport room 12A and the plasma pretreatment room 12B, and the pretreatment roller 20, and the base material 1 can be transported from the base material transport room 12A to the plasma pretreatment room 12B through the gap. The pretreatment roller 20 may be disposed such that the entirety thereof is located in the plasma pretreatment room 12B (not shown in the figure).

The pretreatment roller 20 may include a temperature-adjusting mechanism (not shown in the figure) for adjusting the temperature of the surface of the pretreatment roller 20. For example, the pretreatment roller 20 may include a temperature-adjusting mechanism that includes piping for circulating a temperature regulation medium, such as a refrigerant and a heat transfer medium, inside the pretreatment roller 20. The temperature-adjusting mechanism controls the temperature of the surface of the pretreatment roller 20 to a target temperature, for example, within a range of -20°C or more and 100°C or less.

When the pretreatment roller 20 includes a temperature-adjusting mechanism, it is possible to suppress shrinkage and breakage of the base material 1 due to heat at the time of plasma pretreatment.

The pretreatment roller 20 is formed of a material containing at least one of stainless steel, iron, copper, and chromium. The surface of the pretreatment roller 20 may be subjected to hard chromium plating treatment or the like for scratch prevention. These materials are easy to process. Since the thermal conductivity of the pretreatment roller 20 itself is increased by using the above-mentioned materials as the material for the pretreatment roller 20, the control of the temperature of the pretreatment roller 20 becomes easier.

The electrode section 21 will be described. In the example shown in Figs. 2 and 3, the electrode section 21 includes a first surface 21c facing the pretreatment roller 20 and a second surface 21d being located opposite to the first surface 21c. In the examples shown in Figs. 2 and 3, the electrode section 21 is a plate-shaped member, and the first surface 21c and the second surface 21d are both flat. Plasma is generated between the electrode section 21 and the pretreatment roller 20 by applying an AC voltage between the electrode section 21 and the pretreatment roller 20. The electrode section 21 forms an electric field preferably such that the plasma generated between the electrode section 21 and the pretreatment roller 20 travels in a direction perpendicular to the surface of the base material 1 toward the surface of the base material 1. Consequently, the base material 1 can be efficiently pretreated.

The number of the electrode section 21 is preferably two or more. Two or more electrode sections 21 are preferably aligned along the transport direction of the base material 1. The example shown in Figs. 2 and 3 is an example of a film-forming apparatus 10 having two electrode sections 21. The number of the electrode sections 21 is, for example, 12 or less.

The effect of alignment of two or more electrode sections 21 along the transport direction of the base material 1 will be described. As described above, plasma is generated between the electrode section 21 and the pretreatment roller 20. The region where plasma is generated is enlarged with an increase in the dimension of the electrode section 21 in the transport direction. However, when the electrode section 21 is a flat plate-shaped member, the distance from the end of the first surface 21c of the electrode section 21 facing the pretreatment roller 20 in the transport direction to the pretreatment roller 20 increases with an increase in the dimension of the electrode section 21 in the transport direction, and the treatment performance of plasma decreases.

In the film-forming apparatus 10, two or more electrode sections 21 are aligned along the transport direction of the base material 1. Consequently, even if the dimension of the electrode section 21 in the transport direction of the base material 1 is small, it is possible to generate plasma over a broad range in the transport direction. In addition, the distance from the end of the first surface 21c of the electrode section 21 in the transport direction to the pretreatment roller 20 can be reduced by reducing the dimension of the electrode section 21, and plasma can be generated uniformly in the transport direction.

As shown in Figs. 2 and 3, the electrode section 21 includes a first end 21e and a second end 21f located on the first surface 21c of the electrode section 21. The first end 21e is the upstream end of the base material 1 in the transport direction, and the second end 21f is the downstream end of the base material 1 in the transport direction. As described above, the distances from the first end 21e and the second end 21f of the electrode section 21 in the transport direction to the pretreatment roller 20 can be reduced by reducing the dimension of the electrode section 21 in the transport direction of the base material 1. The dimension of the electrode section 21 in the transport direction of the base material 1 corresponds to the angle θ shown in Fig. 3. The angle θ is an angle formed by a straight line passing through the first end 21e and the rotation axis X and a straight line passing through the second end 21f and the rotation axis X. The angle θ is preferably 20° or more and 90° or less, more preferably 60° or less, and further preferably 45° or less. Within the above range of the angle θ, when the first surface 21c of the electrode section 21 is flat, plasma can be generated uniformly in the transport direction between the electrode section 21 and the pretreatment roller 20.

The material of the electrode section 21 is not particularly limited as long as it has conductivity. Specifically, aluminum, copper, and stainless steel can be suitably used as the material of the electrode section 21.

The thickness L3 of the electrode section 21 viewed in a direction perpendicular to the first surface 21c of the electrode section 21 is not particularly limited, but is, for example, 15 mm or less. When the thickness of the electrode section 21 is the above value, a magnetic field can be effectively formed between the pretreatment roller 20 and the electrode section 21 by the magnetic field-forming section 23. The thickness L3 of the electrode section 21 is, for example, 3 mm or more.

The magnetic field-forming section 23 will be described. As shown in Figs. 2 and 3, the magnetic field-forming section 23 is disposed on the electrode section 21 on the side opposite to the side facing the pretreatment roller 20. The magnetic field-forming section 23 is a member for forming a magnetic field between the pretreatment roller 20 and the electrode section 21. The magnetic field between the pretreatment roller 20 and the electrode section 21 contributes to, for example, the generation of plasma with a higher density when plasma is generated using the plasma pretreatment mechanism 11B. The magnetic field-forming section 23 shown in Figs. 2 and 3 includes a first magnet 231 and a second magnet 232 on the second surface 21d of the electrode section 21.

The number of the magnetic field-forming section 23 is preferably two or more. When the plasma pretreatment mechanism 11B includes two or more electrode sections 21 and two or more magnetic field-forming sections 23, the two or more magnetic field-forming sections 23 are each preferably disposed on the side opposite to the side facing the pretreatment roller 20. In the example shown in Figs. 2 and 3, two magnetic field-forming sections 23 are disposed on the second surfaces 21d of two electrode sections 21, respectively.

The structure of the first magnet 231 and the second magnet 232 in a normal direction of the second surface 21d of the electrode section 21 will be described. As shown in Figs. 2 and 3, the first magnet 231 and the second magnet 232 each have an N pole and an S pole. The symbol N shown in Figs. 2 and 3 indicates the N pole of the first magnet 231 or second magnet 232. The symbol S shown in Figs. 2 and 3 indicates the S pole of the first magnet 231 or second magnet 232. One of the N pole or the S pole of the first magnet 231 is located closer to the base material 1 than the other. The N pole and the S pole of the second magnet 232 are located in reverse relation with those in the first magnet 231 with respect to the base material 1. In the example shown in Figs. 2 and 3, the N pole of the first magnet 231 is located closer to the base material 1 than the S pole of the first magnet 231, and the S pole of the second magnet 232 is located closer to the base material 1 than the N pole of the second magnet. The S pole of the first magnet 231 may be located closer to the base material 1 than the N pole of the first magnet 231, and the N pole of the second magnet 232 may be located closer to the base material 1 than the S pole of the second magnet 232 (not shown in the figure).

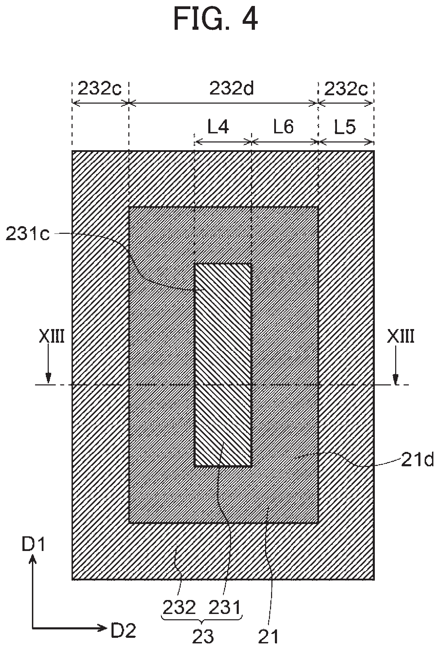

Then, the structure of the first magnet 231 and the second magnet 232 in the surface direction of the second surface 21d of the electrode section 21 will be described. Fig. 4 is a plan view of the electrode section 21 and the magnetic field-forming section 23 shown in Fig. 2 viewed from the magnetic field-forming section 23 side. Fig. 5 is a cross-sectional view illustrating a cross-section along the line VIII-VIII in Fig. 4. In Fig. 4, the direction D1 is a direction in which the rotation axis X of the pretreatment roller 20 extends.

As shown in Figs. 4 and 5, the first magnet 231 includes a first axis direction portion 231c. As shown in Fig. 4, the first axis direction portion 231c extends along the direction D1, i.e., along the rotation axis X of the pretreatment roller 20. The first magnet 231 disposed in one electrode section 21 may include one first axis direction portion 231c or may include two or more first axis direction portions 231c. In the example shown in Fig. 4, the first magnet 231 disposed in one electrode section 21 includes one first axis direction portion 231c.

As shown in Figs. 4 and 5, the second magnet 232 includes a second axis direction portion 232c. As shown in Fig. 4, the second axis direction portion 232c also extends, similar to the first axis direction portion 231c, along the direction D1, i.e., along the rotation axis X.

The first magnet 231 and the second magnet 232 both include portions extending along the rotation axis X, and thereby it is possible to enhance the homogeneity in the intensity of the magnetic field formed in the circumference of the base material 1 in the width direction of the base material 1. Consequently, it is possible to enhance the homogeneity in the distribution density of plasma formed in the circumference of the base material 1 in the width direction of the base material 1.

The second magnet 232 disposed in one electrode section 21 may include one second axis direction portion 232c or may include two or more second axis direction portions 232c. In the example shown in Figs. 4 and 5, the second magnet 232 disposed in one electrode section 21 includes two second axis direction portions 232c. Two second axis direction portions 232c may be located so as to sandwich the first axis direction portion 231c in a direction D2 orthogonal to the rotation axis X in the surface direction of the second surface 21d of the electrode section 21.

The dimension L4 of the first axis direction portion 231c and the dimension L5 of the second axis direction portion 232c in the transport direction of the base material 1 shown in Fig. 5 are not particularly limited. In addition, the ratio of the dimension L4 of the first axis direction portion 231c and the dimension L5 of the second axis direction portion 232c in the transport direction of the base material 1 is not particularly limited. The dimension L4 of the first axis direction portion 231c and the dimension L5 of the second axis direction portion 232c may be the same. Alternatively, the dimension L4 of the first axis direction portion 231c may be larger than the dimension L5 of the second axis direction portion 232c.

The distance L6 between the first axis direction portion 231c and the second axis direction portion 232c in the direction D2 is set such that the magnetic field formed by the first axis direction portion 231c and the second axis direction portion 232c is formed between the pretreatment roller 20 and the electrode section 21.

The second magnet 232 may surround the first magnet 231 when the magnetic field-forming section 23 is viewed along the normal direction of second surface 21d of the electrode section 21. For example, as shown in Fig. 4, the second magnet 232 may include two second axis direction portions 232c and also two connection portions 232d disposed so as to connect the two second axis direction portions 232c.

Examples of the type of the magnet that is used as the magnetic field-forming section 23, such as the first magnet 231 and the second magnet 232, include a ferrite magnet and a permanent magnet of a rare-earth magnet such as neodymium and samarium cobalt (Samacoba). As the magnetic field-forming section 23, an electromagnet can also be used.

The magnetic flux density of the magnet of the magnetic field-forming section 23 such as the first magnet 231 and the second magnet 232 is, for example, 100 Gauss or more and 10,000 Gauss or less. If the magnetic flux density is 100 Gauss or more, a sufficiently strong magnetic field is formed between the pretreatment roller 20 and the electrode section 21, and thereby sufficiently high-density plasma can be generated, and a good pretreated surface can be formed quickly. In order to increase the magnetic flux density of the surface of the base material 1 to greater than 10,000 Gauss, an expensive magnet or magnetic field-generating mechanism is needed.

The plasma pretreatment mechanism 11B may include a plasma source gas supply part (not shown in the figure). The plasma source gas supply part supplies a gas that becomes a raw material of plasma into the plasma pretreatment room 12B. The structure of the plasma source gas supply part is not particularly limited. For example, the plasma source gas supply part is disposed on the wall surface of the plasma pretreatment room 12B and includes a hole from which a gas that is the raw material for plasma is ejected. The plasma source gas supply part may have a nozzle that emits a plasma source gas at a position near the base material 1 than the wall surface of the plasma pretreatment room 12B. Examples of the plasma source gas supplied by the plasma source gas supply part include an inert gas such as argon, an active gas such as oxygen, nitrogen, a carbonic acid gas, and ethylene, and a gas mixture thereof. As the plasma source gas, one of inert gases may be used alone, one of active gases may be used alone, or a gas mixture of two or more inert gases or active gases may be used. As the plasma source gas, it is preferable to use a gas mixture of an inert gas such as argon and an active gas. As an example, the plasma source gas supply part supplies a gas mixture of argon (Ar) and oxygen ($O_2$).

The plasma pretreatment mechanism 11B supplies, for example, plasma with a plasma density of 100 W·sec/m$^2$ or more and 8,000 W·sec/m$^2$ or less between the pretreatment roller 20 and the electrode section 21.

In the example shown in Fig. 2, the plasma pretreatment mechanism 11B is arranged in the plasma pretreatment room 12B that is separated from the base material transport room 12A and the film-forming room 12C by partition walls. The atmosphere of the plasma pretreatment room 12B is easily independently adjusted by partitioning the plasma pretreatment room 12B from other regions such as the base material transport room 12A and the film-forming room 12C. Consequently, for example, the plasma source gas concentration in the space where the pretreatment roller 20 and the electrode section 21 face each other can be easily controlled, and the productivity of the laminated film is improved.

(Film-forming mechanism)

Then, the film-forming mechanism 11C will now be described. In the example shown in Fig. 2, the film-forming mechanism 11C includes a film-forming roller 25 disposed in the film-forming room 12C and an evaporation mechanism 24.

The film-forming roller 25 will be described. The film-forming roller 25 is a roller for winding and transporting the base material 1 pretreated in the plasma pretreatment mechanism 11B with the treated surface of the base material 1 facing outwards.

The material for the film-forming roller 25 will be described. The film-forming roller 25 is preferably formed of a material containing at least one of stainless steel, iron, copper, and chromium. The surface of the film-forming roller 25 may be subjected to hard chromium plating treatment or the like for scratch prevention. These materials are easy to process. Since the thermal conductivity of the film-forming roller 25 itself is increased by using the above materials as the material for the film-forming roller 25, the temperature controlling property is improved when temperature control is performed. The average surface roughness Ra of the surface of the film-forming roller 25 is, for example, 0.1 μm or more and 10 μm or less.

The film-forming roller 25 may include a temperature-adjusting mechanism (not shown in the figure) for adjusting the temperature of the surface of the film-forming roller 25. The temperature-adjusting mechanism includes, for example, a circulation passage for circulating a cooling medium or a heat source medium in the inside of the film-forming roller 25. The cooling medium (coolant) is, for example, ethylene glycol aqueous solution, and the heat source medium (heat medium) is, for example, silicon oil. The temperature-adjusting mechanism may include a heater installed at a position facing the film-forming roller 25. When the film-forming mechanism 11C forms a film by a vapor deposition method, considering the limitations by heat resistance of related mechanical parts and versatility, the temperature-adjusting mechanism preferably controls the temperature of the surface of the film-forming roller 25 to a target temperature within a range of -20°C or more and 200°C or less. When the film-forming roller 25 has a temperature-adjusting mechanism, it is possible to suppress a variation in the temperature of the base material 1 due to the heat that is generated at the time of film formation.

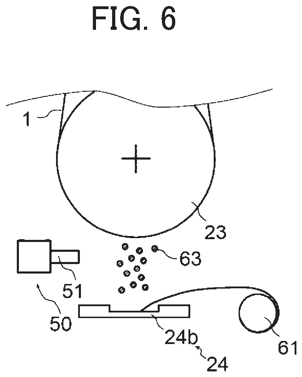

The evaporation mechanism 24 will be described. Fig. 6 is a view illustrating a specific form of the evaporation mechanism 24 in which the part enclosed by the dashed line marked with the symbol IX in Fig. 2 is enlarged and is omitted in Fig. 5 and illustrating a vapor deposition material supply section 61 for supplying a vapor deposition material omitted in Fig. 2. In Fig. 6, the decompression chamber 12 and the partition walls 35b, 35c are omitted from drawing. The evaporation mechanism 24 is a mechanism for evaporating the vapor deposition material containing aluminum. The evaporated vapor deposition material adheres to the base material 1, and thereby a deposition film containing aluminum is formed on the surface of the base material 1. The evaporation mechanism 24 in the present embodiment adopts a resistance heating system. In the example shown in Fig. 6, the evaporation mechanism 24 includes a boat 24b. In the present embodiment, the boat 24b includes a power source (not shown in the figure) and a resistive element (not shown in the figure) electrically connected to the power source. A plurality of the boats 24b may be aligned in the width direction of the base material 1.

As shown in Fig. 6, the film-forming mechanism 11C may include a vapor deposition material supply section 61 that supplies a vapor deposition material to the evaporation mechanism 24. Fig. 6 shows an example in which the vapor deposition material supply section 61 continuously sends aluminum metal wire.

The film-forming mechanism 11C has a gas supply mechanism (not shown in the figure). The gas supply mechanism is a mechanism for supplying a gas between the evaporation mechanism 24 and the film-forming roller 25. The gas supply mechanism at least supplies an oxygen gas. The oxygen gas reacts or binds to an evaporation material, such as aluminum, that is evaporated from the evaporation mechanism 24 and goes towards the base material 1 on the film-forming roller 25. Consequently, a deposition film containing aluminum oxide can be formed on the surface of the base material 1.

The film-forming mechanism 11C includes a plasma supply mechanism 50 that supplies plasma between the surface of the base material 1 and the evaporation mechanism 24. In the example shown in Figs. 2 and 6, the plasma supply mechanism 50 includes a hollow cathode 51. In the present embodiment, the hollow cathode 51 is a negative electrode having a partially opened cavity. The hollow cathode 51 can generate plasma in the cavity. In the example shown in Fig. 6, the hollow cathode 51 is disposed such that the opening of the cavity of the hollow cathode 51 is located diagonally above the boat 24b. The plasma supply mechanism 50 according to the present embodiment includes an anode (not shown in the figure) that faces the opening of the cavity of the hollow cathode 51 and extracts plasma from the opening. Strong plasma can be generated between the surface of the base material 1 and the evaporation mechanism 24 by generating plasma in the cavity of the hollow cathode 51 by the plasma supply mechanism 50 according to the present embodiment and extracting the plasma between the surface of the base material 1 and the evaporation mechanism 24 by the anode facing the plasma. The position of the facing anode is not particularly limited as long as plasma can be extracted from the opening of the cavity of the hollow cathode 51 by the facing anode and can be supplied between the surface of the base material 1 and the evaporation mechanism 24. In the present embodiment, a case in which facing anodes are arranged on both sides of the boat 24b in the width direction of the base material 1 are described. In this case, the film-forming mechanism 11C includes a plurality of boats 24b and a plurality of facing anodes, and the boats 24b and the facing anodes may be alternately aligned in the width direction of the base material 1. The plasma supply mechanism 50 may include a raw material supply device (not shown in the figure) that at least supplies a plasma source gas into the cavity of the hollow cathode 51. As the plasma source gas supplied by the raw material supply device, for example, gases that can be used as the plasma source gas that is supplied by the plasma source gas supply part of the plasma pretreatment mechanism 11B can be similarly used.

The plasma supply mechanism 50 can activate aluminum evaporated in the evaporation mechanism 24 and an oxygen gas and accelerate the reaction or binding between aluminum and oxygen gas by performing plasma assistance at the time of vapor deposition for supplying plasma between the surface of the base material 1 and the evaporation mechanism 24. Consequently, the ratio of aluminum present as aluminum oxide in the deposition film 2 formed on the surface of the base material 1 can be increased, and the characteristics of the deposition film 2 can be stabilized.

The film-forming apparatus 10 may include a base material charge removing section (not shown in the figure) that is located downstream from the film-forming room 12C in the transport direction of the base material 1 in the base material transport room 12A and performs posttreatment for removing the charge generated in the base material 1 due to the film formation by the film-forming mechanism 11C. The base material charge removing section may be provided to remove the charge on one surface of the base material 1 or may be provided to remove the charge on both surfaces of the base material 1.

The device that is used as the base material charge removing section performing posttreatment of the base material 1 is not particularly limited, but, for example, a plasma discharge device, an electron beam irradiation device, an ultraviolet irradiation device, a static elimination bar, a glow discharge device, or a corona treatment device can be used.

When the posttreatment is performed by discharge formation with a plasma treatment device or a glow discharge device, the posttreatment can be performed by using any discharge system, such as alternating current (AC) plasma, direct current (DC) plasma, arc discharge, microwave, or surface wave plasma, by supplying a single discharge gas such as argon, oxygen, nitrogen, and helium or a gas mixture thereof to near the base material 1. In a reduced pressure environment, it is most preferable to perform posttreatment using a plasma discharge device.

The base material 1 can be quickly separated from the film-forming roller 25 at a predetermined position and transported by installing the base material charge removing section at a position downstream from the film-forming room 12C in the transport direction of the base material 1 in the base material transport room 12A and removing the charge of the base material 1. Consequently, base material transportation can be stabilized, breakage or a decrease in quality of the base material 1 due to charging are prevented, and post-processing suitability can be improved by improved wettability on both base material surfaces.

(Power source)

In the example shown in Fig. 2, the film-forming apparatus 10 further includes a power source 32 electrically connected to the pretreatment roller 20 and the electrode section 21. In the example shown in Fig. 5, the power source 32 is electrically connected to the pretreatment roller 20 and the electrode section 21 through the power supply wiring 31. The power source 32 is, for example, an AC power source. When the power source 32 is an AC power source, the power source 32 can apply, for example, an AC voltage having a frequency of 20 kHz or more and 500 kHz or less between the pretreatment roller 20 and the electrode section 21. The input power that can be applied by the power source 32 (power that can be applied per 1 m width of the electrode section 21 in the width direction of the base material 1) is not particularly limited, but is, for example, 0.5 kW/m or more and 20 kW/m or less. The pretreatment roller 20 may be installed at an electrically ground level or may be installed at an electrically floating level.

(Method for manufacturing barrier film)

Then, a method for manufacturing the barrier film shown in Fig. 1 will be described using the above-described film-forming apparatus 10. First, a first film-forming process for forming a first deposition film on the surface of the base material 1 (hereinafter, also simply referred to as film-forming process) will be described. In the formation of a film using the film-forming apparatus 10, a plasma pretreatment process of performing plasma pretreatment of the surface of the base material 1 by the plasma pretreatment mechanism 11B and a film-forming process of forming a deposition film on the surface of the base material 1 by the film-forming mechanism 11C are performed while transporting the base material 1 along the above-described transport route of the base material 1. The transport speed of the base material 1 is preferably 200 m/min or more and more preferably 400 m/min or more and 1,000 m/min or less.

(Plasma pretreatment process)

The plasma pretreatment process is performed by, for example, the following method. Firstly, a plasma source gas is supplied into the plasma pretreatment room 12B. Secondly, the above-mentioned AC voltage is applied between the pretreatment roller 20 and the electrode section 21. When the AC voltage is applied, input power control or impedance control may be performed.

Oxygen alone or a gas mixture of an oxygen gas and an inert gas as the plasma source gas that is supplied in the pretreatment is supplied from a gas storing section through a flow rate controller while measuring the gas flow rate. Examples of the inert gas include one or a mixture of two or more selected from the group consisting of argon, helium, and nitrogen.

In the plasma treatment, the mixture ratio of an oxygen gas and the inert gas, oxygen gas / inert gas, is preferably 6/1 to 1/1 and more preferably 5/2 to 3/2.5.

The film-forming energy of the vapor deposited aluminum on a resin base material is increased by controlling the mixture ratio to 6/1 to 1/1, and the degree of oxidation of the aluminum oxide deposition film is increased to secure the adhesion between the aluminum oxide deposition film and the base material 1 by further controlling the mixture ratio to 5/2 to 3/2.

Glow discharge and plasma generation are simultaneously performed by application of an AC voltage, and the density of the plasma P between the pretreatment roller 20 and the magnetic field-forming section 23 is increased. Thus, plasma P can be supplied between the pretreatment roller 20 and the magnetic field-forming section 23. This plasma P can perform plasma (ion) pretreatment of the surface of the base material 1.

The plasma intensity per unit area in the plasma treatment is 50 W·sec/m$^2$ or more and 8,000 W·sec/m$^2$ or less. If the plasma intensity is less than 50 W·sec/m$^2$, the effect of the plasma pretreatment is not observed, and if the plasma density is 8,000 W·sec/m$^2$ or more, deterioration of the resin base material by the plasma, such as waste, breakage, coloring, or sintering of the resin base material, tends to occur. In particular, in order to obtain an aluminum oxide layer, the plasma intensity in the plasma pretreatment is preferably 100 W·sec/m$^2$ or more and 1,000 W·sec/m$^2$ or less.

The pressure inside the plasma pretreatment room 12B when an AC voltage is applied between the pretreatment roller 20 and the electrode section 21 is reduced to the atmospheric pressure or less by the decompression chamber 12. In this case, the pressure in the plasma pretreatment room 12B is adjusted, for example, such that glow discharge can be generated between the pretreatment roller 20 and the electrode section 21 by the application of the AC voltage. The pressure in the plasma pretreatment room 12B when an AC voltage is applied between the pretreatment roller 20 and the electrode section 21 can be set and maintained to about 0.1 Pa or more and 100 Pa or less and is particularly preferably 1 Pa or more and 20 Pa or less.

The function of the magnetic field-forming section 23 in the plasma pretreatment process will be described. The magnetic field-forming section 23 forms a magnetic field between the pretreatment roller 20 and the electrode section 21. The magnetic field can function so as to capture and accelerate electrons present between the pretreatment roller 20 and the electrode section 21. Consequently, in the region where the magnetic field is formed, since it is possible to increase the collision frequency between electrons and plasma source gas, increase the plasma density, and localize plasma, the efficiency of plasma pretreatment can be improved.

(First film-forming process)

In the film-forming process, a film is formed on the surface of the base material 1 using the film-forming mechanism 11C. As an example of the film-forming process, a case of forming an aluminum oxide deposition film by using the film-forming mechanism 11C including the evaporation mechanism 24 shown in Fig. 6 will be described.

A vapor deposition material containing aluminum is supplied into the boat 24b of the evaporation mechanism 24 so as to face the film-forming roller 25. As the vapor deposition material, aluminum metal wire can be used. In the example shown in Fig. 6, a vapor deposition material is supplied to the boat 24b by continuously sending aluminum metal wire into the boat 24b by the vapor deposition material supply section 61.

Aluminum is evaporated in the boat 24b by heating. Fig. 6 conveniently shows evaporated aluminum vapor 63. The oxygen gas for oxidizing aluminum may be supplied by oxygen alone or in a gas mixture with an inert gas such as argon, and both barrier properties and transparency can be achieved by controlling the oxygen amount. The pressure on this occasion is preferably 0.05 Pa or more and 8.00 Pa or less.

In the film-forming mechanism 11C, a cold trap (not shown in the figure) may be disposed. The cold trap is a device for removing moisture in the film-forming mechanism 11C by cooling. In general, since the key of the film-forming process is a reduction in the moisture amount in the vapor deposition chamber, in a vapor deposition device for production, the basic device configuration is to decrease the moisture amount by operating the cold trap. However, according to the findings by the present inventors, it was clarified that the moisture contained in a polyester base material is also decreased by operating the cold trap and consequently the effect of the introduction of hydroxyl groups by aging treatment after the film-forming process described later decreases.

Accordingly, when the barrier film of the present invention is manufactured, the cold trap is not intentionally operated in order to allow the moisture contained in the polyester base material to remain. That is, a plasma pretreatment that can effectively remove only the moisture on the surface of a polyester base material before film formation, a film-forming process without operation of a cold trap, and aging treatment after the film-forming process are combined to make the aging treatment after film formation effective, and it has been succeeded to achieve both improved barrier property and transparency.

(Plasma assistance at the time of vapor deposition)

The following plasma assistance process at the time of vapor deposition is not indispensable in manufacturing of the barrier film of the present invention.

A method of supplying plasma between the surface of the base material 1 and the evaporation mechanism 24 by the plasma supply mechanism 50, that is, the plasma assistance at the time of vapor deposition, will be described. Plasma is generated in the cavity of the hollow cathode 51 of the plasma supply mechanism 50. Then, discharge is generated between the hollow cathode 51 and the facing anode, and plasma in the cavity of the hollow cathode 51 is extracted between the surface of the base material 1 and the evaporation mechanism 24.

The discharge to be generated between the hollow cathode 51 and the facing anode is arc discharge. The arc discharge means, for example, discharge with a current value of 10 A or more.

Plasma is supplied to the aluminum vapor 63 by evaporating aluminum while supplying plasma between the surface of the base material 1 and the evaporation mechanism 24. The supply of plasma can accelerate the reaction or binding between the aluminum vapor 63 and an oxygen gas. Consequently, before the aluminum vapor 63 arrives at the surface of the base material 1, the aluminum vapor 63 can be oxidized. The evaporated and oxidized aluminum adheres to the base material 1 and forms an aluminum oxide deposition film on the surface of the base material 1. Thus, the barrier film can be manufactured.

The plasma source gas that is supplied by the plasma supply mechanism 50 is preferably an argon gas.

(Aging treatment after film-forming process)

The wound body of the barrier film after the film-forming process is subjected to aging treatment (heat treatment) for a predetermined period of time. Consequently, introduction of hydroxyl groups into the aluminum oxide deposition film progresses, and a deposition film having excellent barrier properties, in particular, a water vapor barrier property, can be formed.

The aging temperature is preferably 50°C or more and 60°C or less. The lower limit of the aging time is 24 hours (1 day) or more and more preferably 48 hours (2 days) or more. The upper limit is 144 hours (6 days) or less and more preferably 96 hours (4 days) or less. The aging humidity is not particularly limited, but may be ordinary relative humidity of 40% or more and 70% or less, and high humidity is not necessary.

(Covering layer-forming process)

(First covering layer-forming process)

In a first covering layer-forming process (hereinafter, simply also referred to as covering layer-forming process), a first covering layer can be manufactured by the following method. Firstly, a barrier coating agent is prepared by mixing the above-described metal alkoxide and a water-soluble polymer, and as needed a silane coupling agent, a sol-gel method catalyst, or an acid, and as a solvent, water or an organic solvent, for example, alcohol such as methyl alcohol, ethyl alcohol, and isopropanol. Secondly, the barrier coating agent is applied onto an aluminum oxide deposition film and dried by usual methods. In this drying process, polycondensation of the metal alkoxide and silanol generated from the silane coupling agent further progresses to form a coating film. The drying conditions are heating treatment at a temperature range of 20°C to 200°C and not higher than the melting point of the plastic base material, preferably 50°C to 180°C, for 3 seconds to 10 minutes. Consequently, a covering layer of the barrier coating agent can be formed on the aluminum oxide deposition film. The above-described application procedure may be repeated to further form a plurality of coating films composed of two or more layers on the first coating film.

The wound body of the barrier film after the covering layer-forming process is subjected to aging treatment (heat treatment) for a predetermined period of time. Consequently, condensation of the covering layer adequately progresses, and a barrier film with barrier properties that are less likely to deteriorate can be obtained.

The lower limit of the aging temperature after the covering layer-forming process is preferably 40°C or more and more preferably 50°C or more. The upper limit is preferably 100°C or less and more preferably 70°C or less. The lower limit of aging time is 24 hours (1 day) or more and more preferably 48 hours (2 days) or more. The upper limit is 144 hours (6 days) or less and more preferably 96 hours (4 days) or less. The aging humidity is not particularly limited, but may be ordinary relative humidity of 40% or more and 70% or less, and high humidity is not necessary.

(Second film-forming process)

An aluminum oxide deposition film is further formed on the first covering layer to form the second deposition film 132b in Fig. 1. The film can be formed under the same conditions as those in the above-described plasma pretreatment process, first film-forming process, and aging treatment. The first deposition film and the second deposition film may be formed under the same conditions or different conditions.

(Second covering layer-forming process)

Furthermore, a second covering layer 132a in Fig. 1 is further formed on the aluminum oxide deposition film vapor deposited through the second film-forming process. The film can be formed under the same conditions as those in the first covering layer-forming process. The first covering layer and the second covering layer may be formed under the same conditions or different conditions.

<<Laminate>>

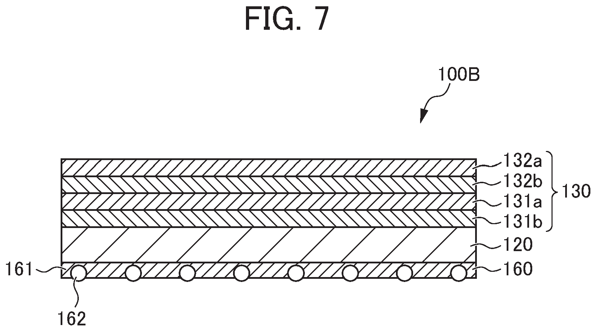

Then, a laminate of the present invention including a barrier film will be described. The laminate 100B in Fig. 7 is an example showing a laminate including a barrier film of Fig. 1. A matte layer 160 is formed on the surface of the base material 120 opposite to the first deposition film 131b, compared to the barrier film 100A in Fig. 1. The laminate of the present invention is suitably used for a wavelength conversion sheet or the like.

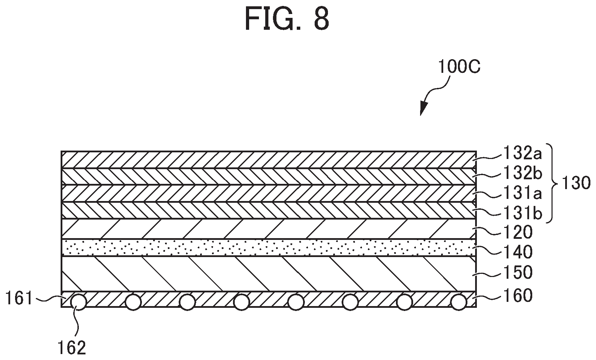

In the laminate 100C of Fig. 8, the base material 120 of the barrier film 100A and a support 150 are laminated with a tackifier layer or adhesive layer 140 (hereinafter, referred to as sticky adhesive layer 140) therebetween. The matte layer 160 is formed on the surface of the support 150 opposite to the barrier film 100A.

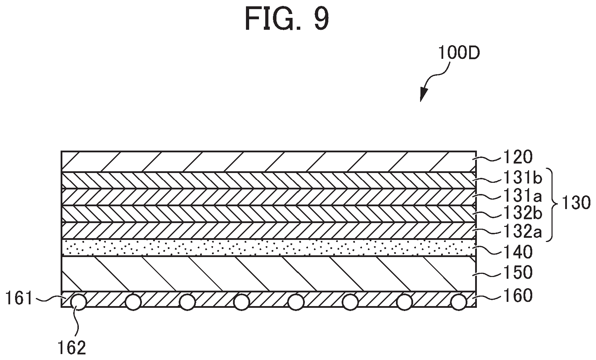

In the laminate 100D of Fig. 9, the barrier layer 130 of the barrier film 100A and a support 150 are laminated with a tackifier layer or adhesive layer 140 (hereinafter, referred to as sticky adhesive layer 140) therebetween. That is, the laminate 100D differs from Fig. 8 in that the barrier film 100A is placed in reverse direction.

Thus, the matte layer 160 may be formed on the surface of the base material 120 opposite to the first aluminum oxide deposition film 131b. Specifically, the matte layer 160 may be formed on one surface of the base material 120. Such a case includes not only a matte layer formed directly on the surface but also a matte layer formed on the surface with a primer layer or the like therebetween. Alternatively, a matte layer may be formed on one surface of the base material 120 with another support 150 or the like therebetween.

Each layer of the laminates 100B, 100C, and 100D will be described below.

[Matte Layer]

The matte layer 160 is a layer with an uneven surface and is, for example, a sticking prevention layer or a light diffusing layer. The matte layer can effectively suppress sticking between the wavelength conversion sheet and a light guide plate 330 or a light diffusion plate 370 or can diffuse light entering into or exiting from the wavelength conversion sheet to further enhance the optical wavelength conversion efficiency.

In Figs. 7 to 9, the matte layer 160 is a layer containing a resin 161 and particles 162, and the surface of the matte layer 160 containing the particles has an uneven surface by protrusion of at least a part of the particles. Here, the phrase "matte layer in which at least a part of the particles protrudes" means that the surface of the matte layer is not uniformly flat and that the surface of the matte layer is rugged by the particles and/or at least a part of the particles is exposed from the surface of the matte layer.

The matte layer may be in a form not containing particles as long as an uneven surface can be formed.

<Sticking prevention layer>

When the matte layer 160 is a sticking prevention layer, sticking between the wavelength conversion sheet and the light guide plate 330 or the light diffusion plate 370 can be effectively suppressed, and chipping of the protrusion of the prism sheet 340 by rubbing can be prevented.

Furthermore, a barrier film or a wavelength conversion sheet wound into a roll can also be prevented from sticking to itself by providing a sticking prevention layer to the barrier film. Accordingly, the barrier film or the wavelength conversion sheet can be stored or transported in a rolled form.

In particular, when a display device is transported in a state in which a light guide plate is disposed on the surface of the sticking prevention layer of the wavelength conversion sheet, the sticking prevention layer and the light guide plate are rubbed with each other, and scratches may occur on the sticking prevention layer. Alternatively, the sticking prevention layer and the light guide plate are rubbed with each other, and debris is generated from the sticking prevention layer, and the debris may scratch the sticking prevention layer or the light guide plate. Such scratches of the sticking prevention layer or light guide plate may cause poor appearance of the display device.

Accordingly, in the laminate according to the present embodiment, among particles protruding from this sticking prevention layer, the proportion of particles having a particle diameter of twice or more the thickness of the sticking prevention layer, that is, the proportion of particles visually recognized to have a particle diameter of twice or more the thickness of the sticking prevention layer to particles protruding from the sticking prevention layer in a planar view of the sticking prevention layer, is preferably 20% or more and 80% or less based on the total amount of the particles extruding from the sticking prevention layer. If this proportion of particles is less than 20%, the scratch resistance of the matte layer is deteriorated, and further, it may be impossible to effectively suppress the sticking between the wavelength conversion sheet and the light guide plate or the like. If this proportion of particles is higher than 80%, the scratch resistance of the matte layer may be deteriorated. Here, the thickness of the sticking prevention layer is the thickness of the layer of the resin 161 constituting the sticking prevention layer.

In the laminate according to the present embodiment, the total number of particles in a 1 mm$^2$ square of the sticking prevention layer in a planar view is preferably 1,800 or more. Consequently, sticking between the wavelength conversion sheet and the light guide plate or the like can be effectively suppressed, and the scratch resistance of the sticking prevention layer may be improved. The upper limit of the total number of particles in a 1 mm$^2$ square of the sticking prevention layer in a planar view is not particularly limited, but is, for example, 20,000 or less and more preferably 15,000 or less. Here, the total number of particles in a 1 mm$^2$ square of the sticking prevention layer in a planar view refers to the total number of particles appearing on the surface of the sticking prevention layer when viewed from the surface side of the sticking prevention layer, and does not include the number of particles that are buried in the sticking prevention layer and cannot be visually recognized.

The proportion of particles having a diameter that is visually recognized to be twice or more can be measured by, for example, observing the surface of the sticking prevention layer of a specified area (e.g., 258 μm × 260 μm) in a planar view with a microscope (for example, a laser microscope or a scanning electron microscope) or the like. The measurement screen is adjusted as needed so that the flat portion is horizontal. An image is acquired, and the luminance is adjusted such that the particle portion can be extracted. The particles and the particle diameters are calculated from the image with adjusted luminance. The proportion of particles visually recognized to have a particle diameter twice or more the thickness of the sticking prevention layer is calculated from the thickness of the sticking prevention layer calculated from the application amount or the like.

The total number of particles in a 1 mm$^2$ square of the sticking prevention layer in a planar view can be calculated by converting the total number of particles in this specified area (e.g., 258 μm × 260 μm) into that in 1 mm × 1 mm.

As the microscope for determining the proportion of particles and the total number of particles in a 1 mm$^2$ square in a planar view, for example, a laser microscope manufactured by Olympus Corporation, OLS 4000, can be used.

When the proportion of particles protruding from the sticking prevention layer and the total number of particles in a specified area are within the above ranges in the sticking prevention layer, it is possible to effectively suppress the sticking prevention layer and the light guide plate (light diffusion plate) from scratching.

Even when the sticking prevention layer is laminated on the surface of the wavelength conversion sheet opposite to the light guide plate (light diffusion plate) and the sticking prevention layer and the optical film are in contact with each other, the above is the same. That is, when the proportion of particles protruding from the sticking prevention layer and the total number of particles in a specified area in the sticking prevention layer are within the above ranges, it is possible to effectively suppress the sticking prevention layer and the optical film from scratching.

In particular, when the optical film is a prism sheet, the prism may be chipped due to the shape of the prism sheet. This means that the prism sheet is easily scratched even when compared to other optical films.

Accordingly, when a prism sheet is used as the optical film, the optical film (prism sheet) can be effectively suppressed from scratching by laminating a sticking prevention layer in which the proportion of particles protruding from the sticking prevention layer and the total number of particles in a specified area are within the above ranges on the surface of the wavelength conversion sheet opposite to the light guide plate (light diffusion plate).

This particle 162 preferably contains a resin having a compressive strength of 2.8 kgf/mm$^2$ or more. This resin has more preferably a compressive strength of 3.0 kgf/mm$^2$ or more and further preferably of 4.0 kgf/mm$^2$ or more. Examples of the resin having a compressive strength of 2.8 kgf/mm$^2$ or more include acrylic resins. When the particle 162 has a compressive strength of 2.8 kgf/mm$^2$ or more, problems such as particles being crushed or scraped by a foreign substance are less likely to occur, a foreign substance is less likely to directly scratch the surface of the sticking prevention layer, and the effect of improving the scratch resistance is obtained. The acrylic resin is a polymer including, as a monomer component, an ethylenically unsaturated monomer having at least one carboxyl group or a carboxylic acid ester group selected from the group consisting of methacrylic acid, acrylic acid, a methacrylic acid ester, and an acrylic acid ester. If the compressive strength of the particle 162 is less than 2.8 kgf/mm$^2$, which is not preferable because that the particles are crushed or scraped when a foreign substance or the like is mixed in, and the foreign substance is likely to scratch directly the surface of the sticking prevention layer to reduce the scratch resistance, which is not preferable.

The thickness of the sticking prevention layer is not particularly limited as long as the effects of the present invention can be exhibited. For example, the thickness is preferably 1.0 μm or more and 50.0 μm or less and more preferably 1.5 μm or more and 10.0 μm or less. The thickness of the sticking prevention layer means the thickness of the resin portion excluding particles in the sticking prevention layer and does not include the thickness of the particle protruding (appearing) on the resin. The thickness of the sticking prevention layer can be measured by, for example, observing a cross-section with a scanning electron microscope or the like.

In order to adjust the thickness of the sticking prevention layer within the above range, the application amount of the sticking prevention layer after drying is preferably 1.0 g/m$^2$ or more and 3.6 g/m$^2$ or less. Within such a range, it is possible to suppress particles from being buried in the sticking prevention layer and suppress impurities from entering between the sticking prevention layer and the light guide plate. If the application amount of the sticking prevention layer after drying is less than 1.0 g/m$^2$, the sticking prevention layer is thin relative to the particles, and there is a possibility that impurities enter between the sticking prevention layer and the light guide plate (light diffusion plate) to scratch the matte layer and the light guide plate (light diffusion plate). If the application amount of the sticking prevention layer after drying is greater than 3.6 g/m$^2$, particles are buried in the sticking prevention layer, and there is a possibility that the function as a sticking prevention layer is deteriorated.

The sticking prevention layer preferably has a haze value of 10% or more and 35% or less and more preferably 10% or more and 25% or less. When the haze value of the sticking prevention layer is 10% or more, the number of particles contained in the sticking prevention layer is sufficient, the scratch resistance of the sticking prevention layer can be improved, and also sticking between the sticking prevention layer and the light guide plate or the like can be effectively suppressed. When the haze value of the sticking prevention layer is 35% or less, the scratch resistance of the sticking prevention layer can be improved, and the function as a display device can be improved.

If the haze value of the sticking prevention layer is less than 10%, since the number of particles contained in the sticking prevention layer is insufficient, the scratch resistance of the sticking prevention layer is deteriorated, and further, it may be impossible to effectively suppress the sticking between the sticking prevention layer and the light guide plate. If the haze value of the sticking prevention layer is greater than 35%, the scratch resistance of the sticking prevention layer is deteriorated, and further, since the haze value is too high, the function as a display device decreases. The haze value can be measured by using a haze meter in accordance with JIS K7136. The haze value of a matte layer (sticking prevention layer) can be determined by subtracting the haze value of the base material such as a PET film alone from the haze value after forming the sticking prevention layer on the PET film as the base material.

(Resin)

The resin 161 contained in the sticking prevention layer is not particularly limited as long as the purpose of the sticking prevention layer can be achieved, and examples thereof include an acrylic resin, an epoxy resin, a urethane resin, a polyester resin, a polyester acrylate resin, a polyurethane acrylate resin, an acrylic urethane resin, and an epoxy acrylate resin. In particular, from the viewpoint of having hardness, an acrylic resin is preferable.

When an acrylic resin is contained in the sticking prevention layer, the proportion of the acrylic resin to the 100 parts by mass of the resins contained in the sticking prevention layer is preferably 60 parts by mass and more preferably 80 parts by mass or more.

(Particle)

The particle is formed in a spherical shape and suppresses sticking between the light guide plate and the wavelength conversion sheet. The type of the particle is not particularly limited, and examples thereof include an acrylic resin, a polystyrene resin, a polyethylene resin, and the like. The particle preferably contains a resin having a compressive strength of 2.8 kgf/mm$^2$ or more measured in accordance with JIS A 9511, such as an acrylic resin and a polystyrene resin. As a particle other than the particles containing an acrylic resin or polystyrene resin, for example, a silica fine particle, melamine, nylon, and benzoguanamine fine particle can be used. The hardness of these materials is, in order from the highest to the lowest, a silica fine particle, melamine, nylon, a polystyrene resin, an acrylic resin, and a polyethylene resin.

The particles preferably have an average particle diameter of 1 μm or more and 50 μm or less and more preferably 1.5 μm or more and 10 μm or less. When the particles have an average particle diameter of 1 μm or more, at least a part of the particles is more exposed from the surface of the sticking prevention layer, sticking between the sticking prevention layer and the light guide plate 330 is more effectively suppressed, and the scratch resistance of the sticking prevention layer can be improved. When the particles have an average particle diameter of 50 μm or less, it is possible to suppress a decrease in the function of the sticking prevention layer by detachment of the particle from the sticking prevention layer and occurrence of a scratch in the sticking prevention layer due to the detached particle.

The average particle diameter is obtained, for example, as the value of D50 in particle size distribution measurement based on JIS Z8820 and Z8822. The average particle diameter can be measured by, for example, a dynamic light scattering system, a laser diffraction scattering system, or SEM or TEM observation.

The content of the particle is preferably 5 mass% or more and 50 mass% or less and more preferably 10 mass% or more and 40 mass% or less based on the total amount of the sticking prevention layer. When the content is 5 mass% or more, sticking between the sticking prevention layer and another member such as the light guide plate can be more effectively prevented. When the content is 50 mass% or less, a sufficient amount of the resin for forming the sticking prevention layer can be secured, and the formability of the sticking prevention layer is improved.

The content of particles protruding from the sticking prevention layer among the particles contained in the sticking prevention layer is preferably 2 mass% or more and 25 mass% or less and more preferably 5 mass% or more and 20 mass% or less based on the total amount of the sticking prevention layer.

The difference between the refractive index of the particles and the refractive index of the resin contained in the sticking prevention layer is preferably 0.5 or less, more preferably 0.3 or less, and further preferably 0.1 or less.

(Additive)

To the sticking prevention layer according to the present embodiment, a stabilizer, a curing agent, a crosslinking agent, a lubricant, a UV absorber, and other additives may further be added as needed.

<Light diffusing layer>

When the matte layer is the light diffusing layer, it is possible to diffuse light entering into or exiting from the wavelength conversion sheet to further enhance the optical wavelength conversion efficiency. The light diffusing layer may be in a form not containing particles as long as an uneven surface can be formed.

When the light diffusing layer contains a resin and a particle, the resin and the particle may be the same as those contained in the sticking prevention layer, and therefore, the description thereof is omitted here.

[Support]

In the laminate according to the present embodiment, as shown in Figs. 8 and 9, a support 150 may be disposed between the barrier film and the matte layer 160. The support 150 is a layer mainly containing a resin, and the resin similar to resins described for the base material 120 can be used.

In the laminate of Figs. 8 and 9, the thickness of the support 150 is preferably greater than 25 $\mu$m and 200 $\mu$m or less, more preferably 38 $\mu$m or more and 175 $\mu$m or less, and further preferably 50 $\mu$m or more and 150 $\mu$m or less. When the thickness of the support 150 is greater than 25 $\mu$m and 200 $\mu$m or less, the flexibility of the wavelength conversion sheet is improved, and the handling ability when combining with the backlight source of the display device is improved.

The support preferably has a high total light transmittance measured in accordance with JIS K 7361 in order to avoid blocking of light from the backlight source. Specifically, the total light transmittance of the support measured in accordance with JIS K 7361 is preferably 85% or more and more preferably 90% or more.

[Sticky adhesive layer]

In the laminate according to the present embodiment, as shown in Figs. 8 and 9, a sticky adhesive layer 140 may be disposed between the barrier film and the support 150. The sticky adhesive layer means a tackifier layer or an adhesive layer. Examples of the adhesive constituting the sticky adhesive layer 140 include a polyvinyl acetate adhesive; a polyacrylic ester adhesive made from a homopolymer such as ethyl, butyl, or 2-ethylhexyl ester or a copolymer thereof with methyl methacrylate, acrylonitrile, styrene, or the like; a cyanoacrylate adhesive; an ethylene copolymer adhesive made from a copolymer of ethylene with a monomer such as vinyl acetate, ethyl acrylate, acrylic acid, or methacrylic acid; a cellulose adhesive; a polyester adhesive; a polyamide adhesive; a polyimide adhesive; an amino resin adhesive made from a urea resin or a melamine resin; a phenolic resin adhesive; an epoxy adhesive; a polyurethane adhesive; a reactive (meth)acrylic adhesive; a rubber adhesive made from chloroprene rubber, nitrile rubber, or styrene-butadiene rubber; silicone adhesive; an inorganic adhesive made from an alkali metal silicate or low-melting glass; and the like.

The tackifier constituting the sticky adhesive layer is not particularly limited as long as it has a desired adhesive force, and examples thereof include acrylic, urethane, rubber, and silicone tackifiers. Among these tackifiers, an acrylic tackifier is preferable because of its excellent durability such as heat resistance and transparency and its low cost. Examples of the acrylic tackifier include an acrylic acid ester copolymer obtained by copolymerizing an acrylic acid ester with another monomer. Examples of the acrylic acid ester include ethyl acrylate, n-butyl acrylate, 2-ethylhexyl acrylate, isooctyl acrylate, isononyl acrylate, hydroxyethyl acrylate, propylene glycol acrylate, acrylamide, and glycidyl acrylate. These tackifiers may be used alone or in combination of two or more.

Examples of the monomer include methyl acrylate, methyl methacrylate, styrene, acrylonitrile, vinyl acetate, acrylic acid, methacrylic acid, itaconic acid, hydroxyethyl acrylate, hydroxyethyl methacrylate, propylene glycol acrylate, acrylamide, methacrylamide, glycidyl acrylate, glycidyl methacrylate, dimethylaminoethyl methacrylate, tert-butylaminoethyl methacrylate, n-ethylhexyl methacrylate, and the like. These monomers may be used alone or in combination of two or more.

The sticky adhesive layer may be in any composition form, such as an aqueous type, a solution type, an emulsion type, and a dispersion type, the form may be any of a film sheet, powder, or solid forms, and the adhesion mechanism may be any of chemical reaction type, solvent volatilization type, thermal melting type, and thermal pressure type.

The sticky adhesive layer can be obtained by, for example, coating such as roll coating, gravure coating, knife coating, dip coating, or spray coating or printing, and the coating amount is desirably 0.1 g/m$^2$ or more and 10 g/m$^2$ or less (in a dried state).

Instead of the above sticky adhesive layer made of an adhesive, for example, a resin layer formed of a thermosetting resin or thermoplastic resin containing a crosslinking agent may be laminated. Furthermore, the method for adhesion may be extrusion lamination in which a thermoplastic resin such as EVA, an ionomer, polyvinyl butyral (PVB), or a polyethylene resin is melted, and the melted thermoplastic resin is extruded for lamination.

<<Wavelength conversion sheet>>

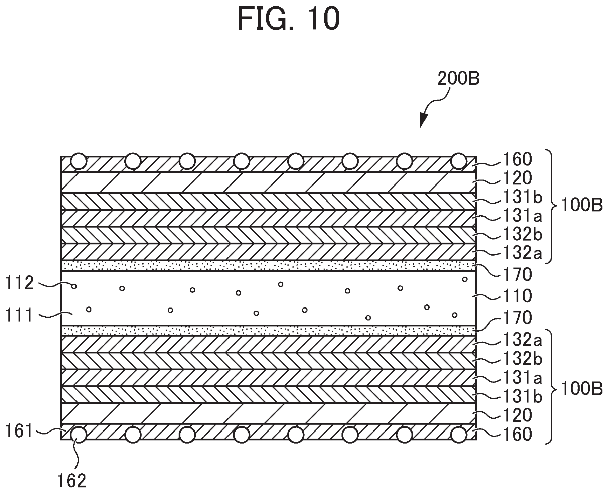

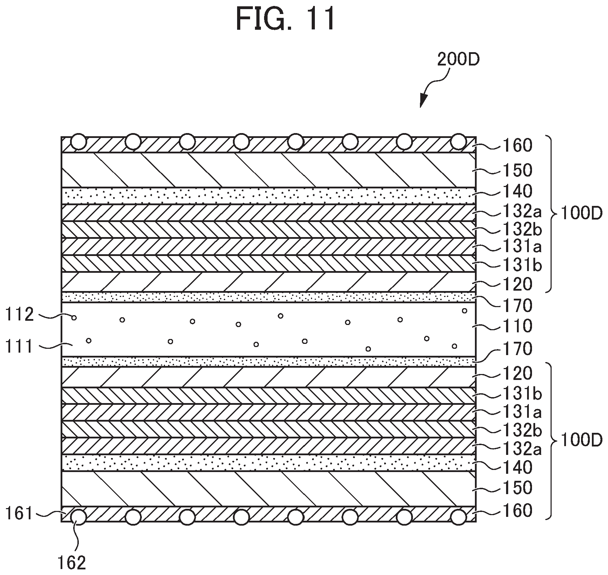

Figs. 10 and 11 are cross-sectional views illustrating examples of the wavelength conversion sheet of the present invention. Specifically, in the wavelength conversion sheet 200B of Fig. 10, the laminate 100B is laminated on both surfaces of a fluorescent substance layer 110 containing a fluorescent substance 112 and a sealing resin 111 through a tackifier layer or adhesive layer 170 (hereinafter, referred to as sticky adhesive layer 170). In the wavelength conversion sheet 200D shown in Fig. 11, the laminate 100D is laminated on both surfaces of a fluorescent substance layer 110 containing a fluorescent substance 112 and a sealing resin 111 through a sticky adhesive layer 170. Barrier properties are imparted to a fluorescent substance layer 110 by laminating the laminate according to the present invention on both surfaces of the fluorescent substance layer 110. In the present specification, both surface sides of a fluorescent substance layer means, when a wavelength conversion sheet is used as a backlight source, both surface sides of the side where the light source is disposed (light input side) and the side opposite from the side where the backlight source is disposed (light output side).

In the wavelength conversion sheets of Figs. 10 and 11, both outermost layers of the laminates are matte layers, but the configuration is not limited thereto. The configuration may be such that the laminate according to the present invention is laminated to only the surface on the light guide plate or light diffusion plate side (not shown in the figure). The configuration may be such that the laminate according to the present invention is laminated to only the surface on the light output side (viewing side) (not shown in the figure). Alternatively, the configuration may be such that the matte layer is not formed, and the barrier film as shown in Fig. 1 may be laminated alone to at least one surface of the fluorescent substance layer.

[Fluorescent substance layer]

The fluorescent substance layer 110 is a layer for adjusting the emission wavelength of the light emitted from the backlight source. The fluorescent substance layer 110 contains one or two or more fluorescent substances consisting of quantum dots.

The quantum dot forming the fluorescent substance 112 is a semiconductor particle of a predetermined size having a quantum confinement effect. The quantum dot absorbs light from an excitation source and, when arrives at an energy excited state, emits energy corresponding to the energy band gap of the quantum dot. The energy band gap can be controlled by controlling the size of the quantum dot or the composition of a substance, and various levels of energy in a wavelength range can be obtained. Especially, a quantum dot can generate strong fluorescence in a narrow wavelength range. Consequently, a display device can be illuminated with three primary colors of light with excellent color purity, and thereby the display device can have excellent color reproducibility.

The fluorescent substance is not particularly limited, and examples thereof include particles containing at least one selected from the group consisting of Group II-VI compounds, Group III-V compounds, Group IV-VI compounds, and Group IV compounds. From the viewpoint of light emission efficiency, the fluorescent substance preferably contains a compound including at least one of Cd and In.

Specific examples of the Group II-VI compound include CdSe, CdTe, CdS, ZnS, ZnSe, ZnTe, ZnO, HgS, HgSe, HgTe, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, CdZnSeS, CdZnSeTe, CdZnSTe, CdHgSeS, CdHgSeTe, CdHgSTe, HgZnSeS, HgZnSeTe, HgZnSTe, and the like. Specific examples of the Group III-V compound include GaN, GaP, GaAs, GaSb, AlN, AlP, AlAs, AlSb, InN, InP, InAs, InSb, GaNP, GaNAs, GaNSb, GaPAs, GaPSb, AlNP, AlNAs, AlNSb, AlPAs, AlPSb, InNP, InNAs, InNSb, InPAs, InPSb, GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and the like. Specific examples of the Group IV-VI compound include SnS, SnSe, SnTe, PbS, PbSe, PbTe, SnSeS, SnSeTe, SnSTe, PbSeS, PbSeTe, PbSTe, SnPbS, SnPbSe, SnPbTe, SnPbSSe, SnPbSeTe, SnPbSTe, and the like. Specific examples of the Group IV compound include Si, Ge, SiC, SiGe, and the like.

The fluorescent substance preferably has a core-shell structure. The quantum efficiency of the fluorescent substance can be more improved when the band gap of the compound constituting the shell is wider than the band gap of the compound constituting the core. Examples of the combination of a core and a shell (core/shell) include CdSe/ZnS, InP/ZnS, PbSe/PbS, CdSe/CdS, CdTe/CdS, CdTe/ZnS, and the like.

The fluorescent substance may have a so-called core-multi-shell structure in which the shell has a multi-layer structure. The quantum efficiency of the fluorescent substance can be further improved by laminating one or more layers of shells having a narrow band gap to a core having a broad band gap and further laminating a shell having a broad band gap on the shell.

The fluorescent substance layer 110 can be formed by laminating a sealing resin 111 containing a fluorescent substance 112. For example, the fluorescent substance layer 110 can be formed by applying a mixture solution containing a fluorescent substance 112 and a sealing resin 111 to the surface of the base material layer and curing it. Examples of the sealing resin 111 include photopolymerizable resins of acrylic resins, such as polyester (meth)acrylate, urethane (meth)acrylate, polyester-urethane (meth)acrylate, polyether (meth)acrylate, polyol (meth)acrylate, melamine (meth)acrylate, isocyanurate (meth)acrylate, epoxy (meth)acrylate, (meth) acrylic resin, and the like; thermosetting resins, such as a phenolic resin, a urea resin, a melamine resin, an epoxy resin, an unsaturated polyester resin, a polyester resin, a silicone resin, a polyurethane resin, and the like; and resins in which a thermoplastic resin such as EVA, an ionomer, polyvinyl butyral (PVB), or a polyethylene resin contains a crosslinking agent or the like. From the viewpoint of adhesion between the fluorescent substance layer and the base material layer, it is preferable to contain at least one resin selected from the group consisting of an acrylic resin, an epoxy resin, a urethane resin, and a polyester resin. These resins may be used alone or as a mixture of one or more. An adhesion layer for enhancing the adhesion may be formed.

[Sticky adhesive layer]

In the wavelength conversion sheet according to the present embodiment, as shown in Fig. 3, a sticky adhesive layer 170 may be disposed between the laminate and the fluorescent substance layer 110. As the sticky adhesive layer 170, the same sticky adhesive agent as those described for the sticky adhesive layer 140 can be used, and therefore, the description thereof is omitted here.

<Method for manufacturing wavelength conversion sheet>

A wavelength conversion sheet is formed in a method below, for example. A sticky adhesive layer 170 is formed on the surface of each of two laminates 100B on the covering layer 130a side, and a mixture solution (ink) containing a fluorescent substance 110 and a sealing resin 111 is applied to the surface of the sticky adhesive layer of one of the laminates 100B. Then, the mixture solution (ink) is brought into contact with the surface of the sticky adhesive layer 170 of the other laminate 100B, and the mixture solution (ink) is cured, thereby the wavelength conversion sheet 200B shown in Fig. 10 can be produced. The wavelength conversion sheet 200D shown in Fig. 11 can also be manufactured similarly. Alternatively, a mixture solution (ink) containing a fluorescent substance 110 and a sealing resin 111 may be directly applied to the surface of the laminate without forming the sticky adhesive layer 170.

<<Display device>>

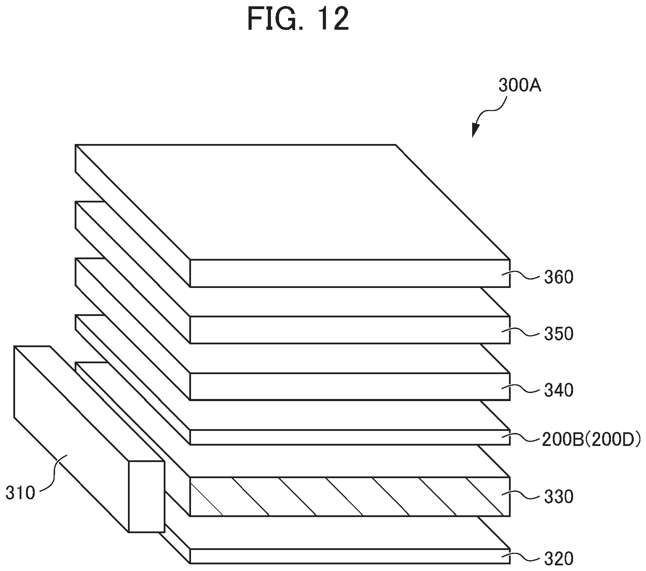

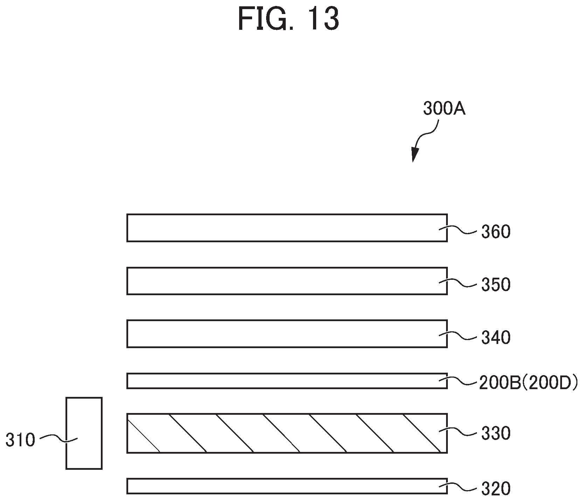

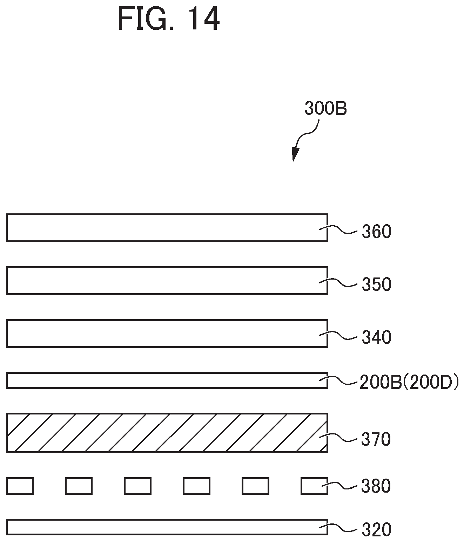

A display device including the wavelength conversion sheet will be described using Figs. 12 to 14. Fig. 12 is a perspective view schematically showing a structure of the surface-mounted display device according to an embodiment of the present invention. Fig. 13 is a cross-sectional view of the display device shown in Fig. 12. The cross-sectional view shown in Fig. 13 is a cross-sectional view of a cross-section that is parallel to the direction in which the wavelength conversion sheet 200B (200D) and so on constituting the display device are laminated and is parallel to the direction in which the light source section and the light guide plate are aligned (the direction in which light emitted from the light source section travels). Fig. 14 is a cross-sectional view schematically showing a structure of the direct-type display device according to an embodiment of the present invention.

In the display device 300A shown in Figs. 12 and 13, an LCD panel 360, a polarization-selective reflection sheet 350, a prism sheet 340, a wavelength conversion sheet 200B (200D), a light guide plate 330, and a reflection sheet 320 are sequentially laminated. In the display device 300A, a light source section 310 is disposed along at least one end surface (side surface) of the light guide plate 330. The light source section 310, the light guide plate 330 or a light diffusion plate 370 described later, and the wavelength conversion sheet 200B (200D) constitute a backlight member of the present invention. The LCD panel 360 is formed of a transmissive liquid crystal display and is a transmissive display section forming image information on its display surface. The polarization-selective reflection sheet 350 is a sheet-shaped member having a function of transmitting light with a specific polarization state and reflecting light with other polarization states, and, for example, DBEF series (manufactured by Sumitomo 3M Limited) can be used. When such a polarization-selective reflection sheet 350 is used, it is preferable from the viewpoint of improving the luminance and improving the light utilization efficiency that the transmission axis of the polarization-selective reflection sheet 350 is parallel to the transmission axis of a polarizer (not shown in the figure) located on the light-receiving side of the LCD panel 360. The prism sheet 340 is an optical sheet having a function of deflecting (focusing) the direction of light going out from the upper surface of the light guide plate 330 to the front direction (the normal direction of the panel surface of the LCD panel).

The light guide plate 330 is an approximately flat plate-shaped member that guides light. The light guide plate 330 receives light emitted by the light source section 310 from one flat plate-shaped end surface, guides the light by total reflection on the top and bottom surfaces of the light guide plate 330 in the light guide plate, and emits the light to the prism sheet 340 side from the upper surface of the light guide plate 330 as appropriate. The reflection sheet 320 is a sheet-shaped member that can reflect light, is disposed on the light guide plate 330 on the side opposite to the prism sheet 340, has a function of reflecting the light going out from the bottom surface of the light guide plate 330 into the light guide plate 330 again, and thereby improves the utilization efficiency of the light emitted from the light source section 310. The reflection sheet 320 mainly made of a material having a mirror reflection property (specular reflection property) is preferable from the viewpoint of enhancing the light utilization efficiency and so on. As the reflection sheet 320, for example, a sheet-shaped member in which at least the reflection surface (the surface on the light guide plate 330 side) is formed of a material having high reflectivity such as a metal or a sheet-shaped member including a thin film formed of a material having high reflectivity (e.g., a metal thin film) as the surface layer can be used. The reflection sheet 320 is not limited to the above and may be, for example, a sheet-shaped member mainly made of a white resin having a diffusion reflection property and having high reflectivity and so on. The light source section 310 is a light source that emits light irradiating the LCD panel 360. From the viewpoint of uniformly injecting light on one end surface of the light guide plate 330, the light source section 310 is formed by, for example, a plurality of point light sources arrayed at predetermined intervals. As the point light source, for example, a light emitting diode (LED) light source or an organic electro luminescence (EL) light source is used. The display device 300A shown in Figs. 12 and 13 is a so-called surface-mounted display device in which light emitted from the light source section 310 that is a backlight source disposed on the end surface of the light guide plate 330 enters the light guide plate 330, guided in the light guide plate, and goes out from the upper surface of the light guide plate 330 is transmitted through the wavelength conversion sheet 200B (200D), the prism sheet 340, the polarization-selective reflection sheet 350, and the LCD panel 360 sequentially. The reflection sheet 320 is provided according to need.

In a so-called surface-mounted display device 300A, the wavelength conversion sheet 200B (200D) is disposed so as to be in contact with the light guide plate 330. Here, in a conventional barrier film for a wavelength conversion sheet or a wavelength conversion sheet, a barrier film and a light guide plate are stuck to each other, which is a factor of significantly deteriorating the display characteristics of the liquid crystal display device. When the display device is transported, the wavelength conversion sheet and the light guide plate are rubbed with each other to scratch the wavelength conversion sheet and/or the light guide plate, which is also a factor of deteriorating the display characteristics of the display device.

However, in a display device including a light guide plate disposed on the surface of the matte layer of the wavelength conversion sheet, even if the display device is a surface-mounted display device, the barrier film and the light guide plate are effectively suppressed from sticking, and the wavelength conversion sheet and/or the light guide plate can be suppressed from being scratched.

The light guide plate may be a conventionally known light guide plate, but in order to effectively prevent sticking between the barrier film and the light guide plate, the shape of the surface of the light guide plate on the side in contact with the barrier film can also be wedge-shaped.

Another display device including the wavelength conversion sheet will be described using Fig. 14. The display device 300B of Fig. 14 is a so-called direct-type display device in which a light source section 380 is disposed on the rear face side of a light diffusion plate 370, a wavelength conversion sheet 200B (200D) is disposed on the light diffusion plate 370 opposite to the light source section 380, and the wavelength conversion sheet 200B (200D) is irradiated with the light emitted from the light source section 380 through the light diffusion plate 370.

In this embodiment, as in the above display device 300A shown in Figs. 9 and 10, a prism sheet 340, a polarization-selective reflection sheet 350, and an LCD panel 360 are laminated in order on the wavelength conversion sheet 200B (200D) on the side opposite to the light diffusion plate 370. In addition, a reflection sheet 320 is disposed on the light source section 380 on the side opposite to the light diffusion plate 370, and the light emitted from the light source section 380 and reflected without entering the light diffusion plate 370 is reflected again to the light diffusion plate 370 side. Thus, the light utilization efficiency can be improved. The light source section 380 shown in Fig. 11 is formed by arranging a plurality of point light sources (LEDs) at equal intervals in a grid pattern along the board surface of the light diffusion plate 370.

In a so-called direct-type display device 300B, the wavelength conversion sheet 200B (200D) is disposed so as to be in contact with the light diffusion plate 370. When the light diffusion plate 370 is disposed on the matte layer 160 of the wavelength conversion sheet 200B (200D), by the same reason as that in the case of the display device 300A, sticking between the barrier film and the light diffusion plate is effectively suppressed, and the wavelength conversion sheet and/or the light diffusion plate can be suppressed from being scratched.

<Method for manufacturing display device>

The display device can be manufactured by a process of disposing a light guide plate or a light diffusion plate on the matte layer side of the wavelength conversion sheet.

EXAMPLES

The present invention will be described in further detail below by Examples, but the present invention is not limited to these descriptions in any way. Barrier films according to Examples 1 to 7 and Comparative Examples 1 to 9 were manufactured using a film-forming apparatus 10 that is a film-forming apparatus according to the present embodiment and a film-forming method. Tables 1 and 2 collectively show the pretreatment conditions, vapor deposition conditions, and so on.

(Example 1)

A plasma pretreatment process and a film-forming process were performed using a biaxially oriented polyethylene terephthalate film (PET film, trade name: PET-F, manufactured by UNITIKA LTD.) having a thickness of 12 $\mu$m as the base material 1 and using the film-forming apparatus 10 shown in Fig. 2.
The PET base material 1 was prepared by a humidity control process in which a rolled original material was rewound in an atmosphere of 25°C and 50% RH and was then stored at 25°C and 50% RH for 3 days for humidity control.
In the pretreatment process, the surface of the base material 1 was plasma-pretreated using the plasma pretreatment mechanism 11B shown in Figs. 2 and 3. Specifically, firstly, the pressure in the plasma pretreatment room 12B was adjusted using a decompression chamber 12 while supplying a plasma-forming gas to the plasma pretreatment room 12B using a plasma source gas supply part. Secondly, a voltage was applied between the pretreatment roller 20 and the electrode section 21 to generate plasma, and the surface of the base material 1 was subjected to plasma pretreatment. The conditions for the plasma pretreatment were as follows:

<Pretreatment conditions>

Transport speed of base material: 670 m/min;
High frequency power output: 4 kW;
High frequency power source frequency: 40 kHz;
Plasma intensity: 550 W·sec/m$^2$;
Plasma-forming gas: oxygen 100 (sccm) and argon 1,000 (sccm);
Magnetic forming method: permanent magnet of 1,000 Gauss;
Voltage applied between pretreatment drum and plasma supply nozzle: 420 V; and
Pressure of pretreatment compartment: $2.0 \times 10^{-1}$ Pa.

In the film-forming process, a deposition film 2 containing aluminum oxide was formed using the evaporation mechanism 24 of a resistance heating system (in Table 1, noted as RH) as shown in Fig. 6 by a vacuum vapor deposition method. Specifically, a deposition film 2 was formed on the surface of the base material 1 by heating the vapor deposition material in the boat 24b using the evaporation mechanism 24 of the resistance heating system while supplying aluminum metal wire as the vapor deposition material into the boat 24b and evaporating aluminum so as to arrive at the surface of the base material 1 while supplying oxygen.
In addition, plasma assistance at the time of vapor deposition was performed using a form of a plasma supply mechanism 50 including the hollow cathode 51 shown in Fig. 6 and anodes (not shown in the figure) located on both sides of the base material 1 in the width direction viewed from the boat 24b and facing the opening of the cavity of the hollow cathode 51 by supplying a plasma source gas (argon gas) to the cavity of the hollow cathode 51, discharging the gas to excite plasma, and extracting this plasma between the surface of the base material 1 and the evaporation mechanism 24 by the facing anodes. The conditions for the plasma assistance were adjusted such that the amount of argon gas supplied to the hollow cathode was 80 sccm, the anode current was 47 A, and the anode voltage was 21 V. The film was formed without operating the cold trap, and plasma posttreatment process after the plasma assistance process at the time of vapor deposition was not performed.
By the above method, a first deposition film was laminated on the base material 1. On this occasion, the transport speed was 670 m/min, and the thickness of the deposition film was 8.0 nm. On this occasion, the light transmittance at a wavelength of 366 nm measured inline after vapor deposition was set based on that the transmittance when the base material 1 was subjected to pretreatment and was not yet vapor-deposited was defined as 100%. Then, vapor deposition was started, and the oxygen supply amount was feedback-controlled such that the light transmittance became 99.7%. The pressure during the vapor deposition was 1.1 Pa.
The wound body of the barrier film after the film-forming process was subjected to aging treatment at 25°C and 50% RH for 3 days.

Furthermore, a first covering layer was laminated on the first deposition film. A solution A having a solid content of 4% was obtained by mixing polyvinyl alcohol having a saponification degree of 99% or more and a polymerization degree of 2,400 as a water-soluble polymer with a solution consisting of water and isopropyl alcohol at a ratio of 95/5. Water, isopropyl alcohol, and 1 N hydrochloric acid were mixed at a ratio of 65/34/1 to prepare a solution B. As a metal alkoxide, tetraethoxysilane was provided as a solution C. A solution D was prepared by mixing the solution B and the solution C at a certain ratio, and a barrier coating agent was prepared by mixing the solution A and the solution D at a certain ratio. The ratio of the solution B and the solution C and the ratio of the solution A and the solution D were adjusted such that the solid content of the barrier coating agent after mixing was 5%, and the mass ratio of tetraethoxysilane in $SiO_2$ equivalent was 2.0 relative to the solid content of PVA. This barrier coating agent was defined as a solution X.

The barrier coating agent prepared above was coated on the first deposition film by a direct gravure method. Subsequently, drying was performed at 140°C to form a covering layer having a dry film thickness of 200 nm, and then aging treatment was performed at 25°C and 50% RH for 3 days to form a first covering layer. The dry film thickness was controlled by changing the gravure plate.

Subsequently, a second deposition film was formed on the first covering layer under the same conditions as in the first deposition film, and further, a second covering layer was formed on the second deposition film under the same conditions as in the first covering layer except that the thickness of the covering layer was 230 nm to manufacture a barrier film of Example 1.

(Example 2)

A barrier film of Example 2 was manufactured as in Example 1 except that plasma assistance was not performed and the transport speed in the film-forming process was 600 m/min, the light transmittance was 94.0, and the pressure was 0.30 Pa.

(Example 3)

In the film-forming process, a biaxially oriented polyethylene terephthalate film (PET film, trade name: P60, manufactured by Toray Industries, Inc.) having a thickness of 12 μm was used as the base material 1, and an anchor coat layer (in Table 1, noted as AC) having a thickness of 200 nm of an acrylic urethane resin was formed on the base material 1. In the film-forming process of the deposition film, the film-forming process and aging treatment were performed as in Example 1 except that an electron beam (EB) heating system (in Table 1, noted as EB) was used instead of the resistance heating system, the plasma pretreatment process was not performed, the transport speed was 480 m/min, the film thickness was 10.0 nm, the oxygen supply amount was feedback-controlled such that the light transmittance at a wavelength of 366 nm measured inline after vapor deposition was 88.0%, the pressure during vapor deposition was 0.2 Pa, and the plasma assistance was not performed. The light transmittance at a wavelength of 366 nm measured inline after vapor deposition was set based on that the transmittance when the base material 1 and the anchor coat layer were present and were not yet vapor-deposited was defined as 100%.

In the covering layer-forming process, the solution Z was used. A barrier film of Example 3 was manufactured as in Example 1 except that the solution Z was prepared as the barrier coating agent by adding 1,3,5-tris(3-trialkoxysilylpropyl)isocyanurate at 15% based on the weight of tetraethoxysilane at the time of mixing the solution B and the solution C and then adjusting the ratio of the solution B and the solution C and the ratio of the solution A and the solution D and mixing them such that as a covering layer, the solid content was 7% and the mass of tetraethoxysilane in $SiO_2$ equivalent was 4.0 relative to the solid content of PVA, the first covering layer had a thickness of 210 nm, the second covering layer had a thickness of 210 nm, and the aging treatment after the covering layer formation was performed at 55°C and 50% RH for 3 days.

(Example 4)

A barrier film of Example 4 was manufactured as in Example 3 except that in the covering layer-forming process, the thicknesses of the first covering layer and the second covering layer were 200 nm and 160 nm, respectively.

(Example 5)

A barrier film of Example 5 was manufactured as in Example 2 except that in the humidity control process, rewinding was performed at 30°C and 60% RH and then humidity control was performed by storage at 30°C and 60% RH for 3 days.

(Example 6)

A barrier film of Example 6 was manufactured as in Example 5 except that in the film-forming process, the aging treatment after film formation was performed at 60°C and 50% RH for 4 days.

(Example 7)

A barrier film of Example 7 was manufactured as in Example 1 except that in the film-forming process, the plasma assistance conditions were an anode current of 56 A.

(Comparative Example 1)

The film-forming process of the first deposition film was performed as in Example 1 except that the transport speed was 600 m/min, the film thickness was 8.9 nm, the cold trap was operated, the plasma assistance conditions were an anode current of 155 A and an anode voltage of 20 V, and the aging treatment after film formation was not performed. In addition, the second deposition film was not formed.

In the forming process of the first covering layer, a solution Y was used. The solution Y as the barrier coating agent was prepared by adding glycidoxypropyltrimethoxysilane at 5% based on the weight of tetraethoxysilane at the time of mixing the solution B and the solution C and then adjusting the ratio of the solution B and the solution C and the ratio of the solution A and the solution D such that the solid content was 5% and the mass of tetraethoxysilane in $SiO_2$ equivalent was 3.4 relative to the solid content of PVA as the covering layer, and mixing them, and the thickness of the first covering layer was set to 300 nm. The second covering layer was not formed, and a barrier film of Comparative Example 1 was manufactured.

(Comparative Example 2)

A barrier film of Comparative Example 2 was manufactured as in Comparative Example 1 except that in the film-forming process, the aging treatment after film formation was performed at 50°C and 50% RH for 2 days.

(Comparative Example 3)

A barrier film of Comparative Example 3 was manufactured as in Comparative Example 1 except that in the film-forming process, the aging treatment after film formation was performed at 55°C and 50% RH for 3 days.

(Comparative Example 4)

A barrier film of Comparative Example 4 was manufactured as in Example 2 except that in the film-forming process, the second deposition film was not formed, and in the covering layer-forming process, the second covering layer was not formed.

(Comparative Example 5)

A barrier film of Comparative Example 5 was manufactured as in Comparative Example 4 except that in the film-forming process of the first deposition film, an EB heating system (in Table 1, noted as EB) was used instead of the resistance heating system, the light transmittance was 88.0%, and the pressure was 0.2 Pa.

(Comparative Example 6)

A barrier film of Comparative Example 6 was manufactured as in Example 1 except that in the film-forming process, the cold trap was operated, and the plasma assistance conditions were an anode current of 168 A and an anode voltage of 23 V.

(Comparative Example 7)

A barrier film of Comparative Example 7 was manufactured as in Comparative Example 6 except that in the film-forming process, the plasma assistance conditions were an anode current of 155 A and an anode voltage of 20 V.

(Comparative Example 8)

A barrier film of Comparative Example 8 was manufactured as in Comparative Example 7 except that in the film-forming process, the transport speed was 530 m/min, the film thickness was 10.0 nm, the light transmittance was 98.0%, and the pressure was 1.0 Pa and except that in the film-forming process, the film thickness was adjusted to 300 nm using the solution Y and the aging treatment after the covering layer formation was performed at 55°C and 50% RH for 3 days.

(Comparative Example 9)

A barrier film of Comparative Example 9 was manufactured as in Comparative Example 7 except that in the film-forming process, the plasma assistance conditions were an anode current of 141 A and an anode voltage of 22 V, the transport speed was 530 m/min, the film thickness was 10.0 nm, the light transmittance was 98.0%, and the pressure was 1.0 Pa.

(Comparative Example 10)

In the film-forming process of the first deposition film of Example 2, the aging treatment after film formation was performed at 60°C and 80% RH for 5 days. Consequently, since the film was broken at the time of unwinding for forming, the first covering layer, the second deposition film, and the second covering layer were not formed. A barrier film was taken from the outermost layer of the roll after aging treatment at 60°C and 80% RH and was evaluated by XAFS.

[Table 1]

| | PET base material | Unwinding Temperature Humidity | Roll storage Temperature Humidity | Presence or absence of AC | Plasma pretreatment | Transport speed (m/min) | Vapor deposition system | Cold trap | Plasma assistance condition | | | Transmittance (%) @366nm | Pressure (Pa) | Aging after vapor deposition |
|---|---|---|---|---|---|---|---|---|---|---|---|---|---|---|
| | | | | | | | | | Hollow cathode Ar flow rate (sccm) | Anode current (A) | Anode voltage (V) | | | |
| Example 1 | PET-F | 25°C 50% RH | 25°C, 50% RH, 3 days | None | Yes | 670 | RH | Non-use | 80 | 47 | 21 | 99.7 | 1.1 | 55°C, 50% RH, 3 days |
| Example 2 | PET-F | 25°C 50% RH | 25°C, 50% RH, 3 days | None | Yes | 600 | RH | Non-use | 0 | 0 | 0 | 94.0 | 0.3 | 55°C, 50% RH, 3 days |
| Example 3 | P60 | 25°C 50% RH | 25°C, 50% RH, 3 days | Yes | None | 480 | EB | Non-use | 0 | 0 | 0 | 88.0 | 0.2 | 55°C, 50% RH, 3 days |
| Example 4 | P60 | 25°C 50% RH | 25°C, 50% RH, 3 days | Yes | None | 480 | EB | Non-use | 0 | 0 | 0 | 88.0 | 0.2 | 55°C, 50% RH, 3 days |
| Example 5 | PET-F | 30°C 60% RH | 30°C, 60% RH, 3 days | None | Yes | 600 | RH | Non-use | 0 | 0 | 0 | 94.0 | 0.3 | 55°C, 50% RH, 3 days |
| Example 6 | PET-F | 30°C 60% RH | 30°C, 60% RH, 3 days | None | Yes | 600 | RH | Non-use | 0 | 0 | 0 | 94.0 | 0.3 | 60°C, 50% RH, 4 days |
| Example 7 | PET-F | 25°C 50% RH | 25°C, 50% RH, 3 days | None | Yes | 670 | RH | Non-use | 80 | 56 | 21 | 99.7 | 1.1 | 55°C, 50% RH, 3 days |
| Comparative Example 1 | PET-F | 25°C 50% RH | 25°C, 50% RH, 3 days | None | Yes | 600 | RH | Use | 80 | 155 | 20 | 99.7 | 1.1 | None |
| Comparative Example 2 | PET-F | 25°C 50% RH | 25°C, 50% RH, 3 days | None | Yes | 600 | RH | Use | 80 | 155 | 20 | 99.7 | 1.1 | 50°C, 50% RH, 2 days |
| Comparative Example 3 | PET-F | 25°C 50% RH | 25°C, 50% RH, 3 days | None | Yes | 600 | RH | Use | 80 | 155 | 20 | 99.7 | 1.1 | 55°C, 50% RH, 3 days |
| Comparative Example 4 | PET-F | 25°C 50% RH | 25°C, 50% RH, 3 days | None | Yes | 600 | RH | Non-use | 0 | 0 | 0 | 94.0 | 0.3 | 55°C, 50% RH, 3 days |
| Comparative Example 5 | PET-F | 25°C 50% RH | 25°C, 50% RH, 3 days | None | Yes | 600 | EB | Non-use | 0 | 0 | 0 | 88.0 | 0.2 | 55°C, 50% RH, 3 days |
| Comparative Example 6 | PET-F | 25°C 50% RH | 25°C, 50% RH, 3 days | None | Yes | 670 | RH | Use | 80 | 168 | 23 | 99.7 | 1.1 | 55°C, 50% RH, 3 days |

| | PET base material | Unwinding Temperature Humidity | Roll storage Temperature Humidity | Presence or absence of AC | Plasma pretreatment | Transport speed (m/min) | Vapor deposition condition | | | | | | | Aging after vapor deposition |
|---|---|---|---|---|---|---|---|---|---|---|---|---|---|---|
| | | | | | | | Vapor deposition system | Cold trap | Plasma assistance condition | | | Transmittance (%) @366nm | Pressure (Pa) | |
| | | | | | | | | | Hollow cathode Ar flow rate (sccm) | Anode current (A) | Anode voltage (V) | | | |
| Comparative Example 7 | PET-F | 25°C 50% RH | 25°C, 50% RH, 3 days | None | Yes | 670 | RH | Use | 80 | 155 | 20 | 99.7 | 1.1 | 55°C, 50% RH, 3 days |
| Comparative Example 8 | PET-F | 25°C 50% RH | 25°C, 50% RH, 3 days | None | Yes | 530 | RH | Use | 80 | 155 | 20 | 98.0 | 1.0 | 55°C, 50% RH, 3 days |
| Comparative Example 9 | PET-F | 25°C 50% RH | 25°C, 50% RH, 3 days | None | Yes | 530 | RH | Use | 80 | 141 | 22 | 98.0 | 1.0 | 55°C, 50% RH, 3 days |
| Comparative Example 10 | PET-F | 25°C 50% RH | 25°C, 50% RH, 3 days | None | Yes | 600 | RH | Non-use | 0 | 0 | 0 | 94.0 | 0.3 | 60°C, 80% RH, 5 days |

[Table 2]

| | Covering layer solution composition | Aging after covering layer | AlOx first deposition film | First covering layer | AlOx second deposition film | Second covering layer |
|---|---|---|---|---|---|---|
| | | | Film thickness (nm) | Film thickness (nm) | Film thickness (nm) | Film thickness (nm) |
| Example 1 | Solution X | 25°C, 50% RH, 3 days | 8.0 | 200 | 8.0 | 230 |
| Example 2 | Solution X | 25°C, 50% RH, 3 days | 8.0 | 200 | 8.0 | 230 |
| Example 3 | Solution Z | 55°C, 50% RH, 3 days | 10.0 | 210 | 10.0 | 210 |
| Example 4 | Solution Z | 55°C, 50% RH, 3 days | 10.0 | 200 | 10.0 | 160 |
| Example 5 | Solution X | 25°C, 50% RH, 3 days | 8.0 | 200 | 8.0 | 230 |
| Example 6 | Solution X | 25°C, 50% RH, 3 days | 8.0 | 200 | 8.0 | 230 |
| Example 7 | Solution X | 25°C, 50% RH, 3 days | 8.0 | 200 | 8.0 | 230 |
| Comparative Example 1 | Solution Y | 55°C, 50% RH, 3 days | 8.9 | 300 | - | - |
| Comparative Example 2 | Solution Y | 55°C, 50% RH, 3 days | 8.9 | 300 | - | - |
| Comparative Example 3 | Solution Y | 55°C, 50% RH, 3 days | 8.9 | 300 | - | - |
| Comparative Example 4 | Solution X | 25°C, 50% RH, 3 days | 8.0 | 200 | - | - |
| Comparative Example 5 | Solution X | 25°C, 50% RH, 3 days | 8.0 | 200 | - | - |
| Comparative Example 6 | Solution X | 25°C, 50% RH, 3 days | 8.0 | 200 | 8.0 | 230 |
| Comparative Example 7 | Solution X | 25°C, 50% RH, 3 days | 8.0 | 200 | 8.0 | 230 |
| Comparative Example 8 | Solution Y | 55°C, 50% RH, 3 days | 10.0 | 300 | 10.0 | 300 |
| Comparative Example 9 | Solution X | 25°C, 50% RH, 3 days | 10.0 | 200 | 10.0 | 230 |
| Comparative Example 10 | - | - | - | - | - | - |

[Acquisition and analysis of XAFS spectrum]

XAFS spectra of the barrier films of Examples 1 to 7 and Comparative Examples 1 to 10 were obtained under the following measurement conditions. Among them, the result of Example 2 is shown in Fig. 15. The vertical axis of the figure is the intensity of generated fluorescent X-rays (in the figure, shown as absorption intensity (a.u.)), and the horizontal axis is the light (or X-ray) energy (eV).

<Acquisition of XAFS spectrum>

- Used line: Aichi Synchrotron Radiation Center BL1N2;
- Acceleration energy: 1.2 GeV;
- Beam size: 1.0 mm in the horizontal direction $\times$ 1.0 mm in vertical;
- Incident angle on sample: 22.5° (the perpendicular direction to the sample is defined as 0°);
- Inlet slit: 30 $\mu$m;
- Outlet slit: 30 $\mu$m;
- Measurement method: partial fluorescence yield;
- Energy range (Al K-edge): 1,500 to 1,700 eV;
- Energy step:

    1,500 to 1,550 eV: 2.0 eV/step;
    1,550 to 1,555 eV: 1.0 eV/step;
    1,555 to 1,575 eV: 0.2 eV/step;
    1,575 to 1,600 eV: 0.5 eV/step;
    1,600 to 1,680 eV: 1.0 eV/step; and
    1,680 to 1,700 eV: 2.0 eV/step,
    (Dwell time: all 10 s/point); and
    Energy calibration: energy calibration using Au 4f 7/2 of Au plate (calibrated with the value obtained by subtracting the theoretical value 1,500 eV from the measured value).

<XAFS spectral analysis>

Peak separation method

The intensity values were normalized such that the absorption spectral intensity value at an absorbed X-ray energy value of 1,540 eV was 0 and the absorption spectral intensity value at an absorbed X-ray energy value of 1,680 eV was 1.

[Math. 1]

$$f(x) = \sum_{i=1}^{3} \frac{h_i}{\{1 + M_i(x-X_i)^2/\beta_i^{\,2}\}\exp\{(1-M_i)[(ln2)(x-X_i)^2]/\beta_i^{\,2}\}}$$

$$+ \sum_{j=1}^{2} \frac{k_j}{\pi}\left(\tan^{-1}(x-K_j) + \frac{\pi}{2}\right)$$

The intensity values at data points from 1,555 eV to 1,575 eV and from 1,595 eV to 1,605 eV after the normalization were extracted, and each coefficient was determined by fitting the above function f(x). However, limiting conditions: $k_1 = k_2$, $K_1 = X_1$, and $K_2 = X_2$ are included. The fitting was performed by a least-square method. On this occasion, the initial values of the coefficients were determined as shown in the following table using the least-square function of the SciPy library of Python. The definition of each of the function symbols is as follows:

$M_i$: weighting factor of Gaussian and Lorentzian functions at the $i$th absorption peak;
$X_i$: peak center of the $i$th absorption peak;
$h_i$: peak intensity factor in the $i$th absorption peak;
$\beta_i$: peak width factor in the $i$th absorption peak;
$k_j$: baseline intensity factor at the $j$th baseline; and
$K_j$: halved position of the baseline intensity at the $j$th baseline.

[Table 3]

| | |
|---|---|
| $h_1$ | 4 |
| $\beta_1$ | 0.8 |
| $M_1$ | 0.8 |
| $X_1$ | 1566 |
| $k_1$ | 1 |
| $K_1$ | 1566 |
| $h_2$ | 4 |
| $\beta_2$ | 0.8 |
| $M_2$ | 0.8 |
| $X_2$ | 1568 |
| $k_2$ | 1 |
| $K_2$ | 1568 |
| $h_3$ | 4 |
| $\beta_3$ | 0.8 |
| $M_3$ | 0.8 |
| $X_3$ | 1570 |

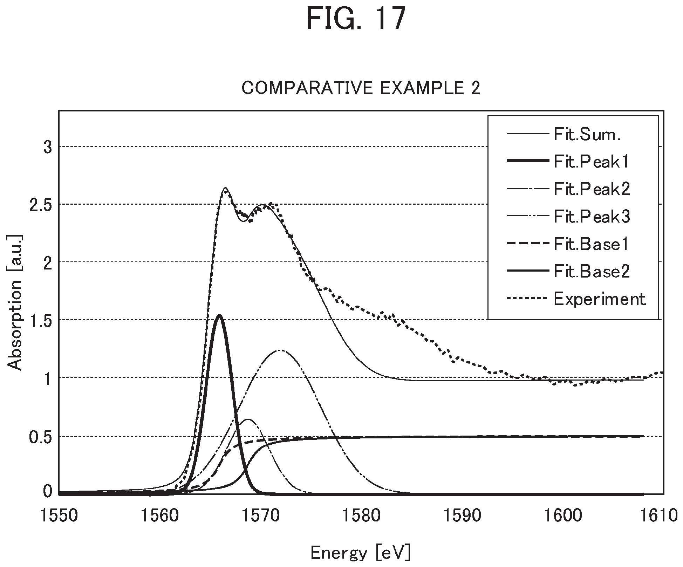

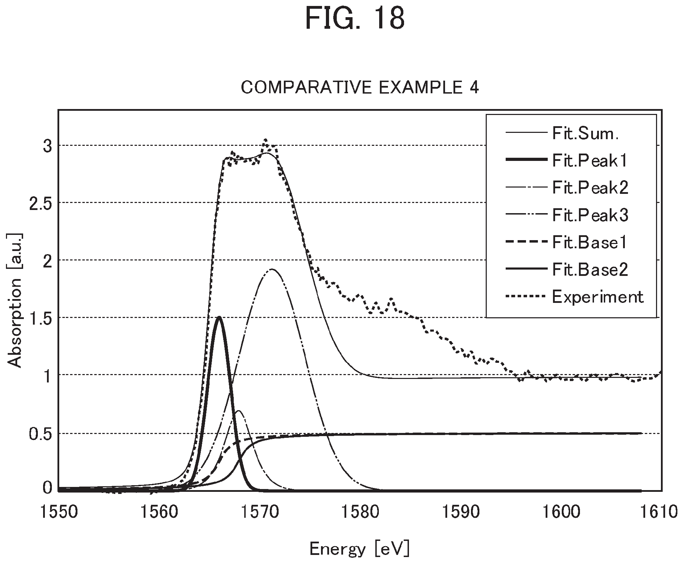

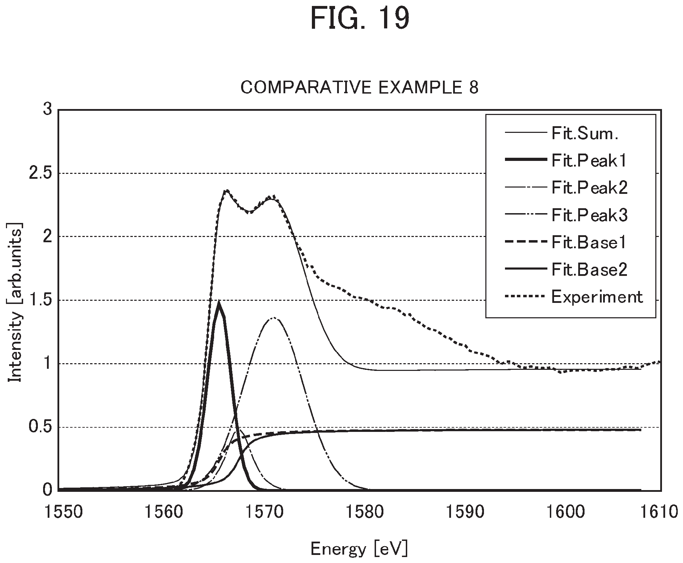

Figs. 16 to 19 show the results of peak separation of the XAFS spectra of Example 2 and Comparative Examples 2, 4, and 8. Fig. 16 shows the analysis results of separated XAFS peaks of Example 2, Fig. 17 shows the analysis results of separated XAFS peaks of Comparative Example 2, Fig. 18 shows the analysis results of separated XAFS peaks of Comparative Example 4, and Fig. 19 shows the analysis results of separated XAFS peaks of Comparative Example 8.

Experiment is an actually measured XAFS spectrum, Fit. Peak 1 is a separated intensity peak at around 1,566 eV, Fit. Peak 2 is a separated intensity peak at around 1,568 eV, and Fit. Peak 3 is a separated intensity peak at around 1,572 eV. From the above, XAFS peak top ratio P = (intensity peak top at around 1,572 eV) / (intensity peak top at around 1,566 eV) was calculated, and Table 4 shows the results of barrier films of Examples 1 to 7 and Comparative Examples 1 to 10.

<TOF-SIMS analysis>

Regarding the barrier films of Examples 1 to 7 and Comparative Examples 1 to 9, the intensities of $C_2^-$ ion (mass number: 24.000), $CN^-$ ion (mass number: 26.0003), $Si^-$ ion (mass number: 27.9777), $AlO_2^-$ ion (mass number: 58.971), and $SiO_2^-$ ion (mass number: 59.9666) in each barrier film were measured using time-of-flight secondary ion mass spectrometry (TOF-SIMS). Specifically, mass analysis of various ions in each layer was performed using a time-of-flight secondary ion mass spectrometer (manufactured by IONTOF GmbH, TOF.SIMS5), while repeating soft-etching at a constant rate with a Cs (cesium) ion gun from the surface of the barrier film towards the PET film side. Table 4 shows the results of the covering layer intensity ratio X = $C_2^-$ ion intensity / $Si^-$ ion intensity (in Table 4, C2/Si intensity ratio). TOF-SIMS measurement conditions:

- Primary ion type: $Bi^{3++}$ (0.2 pA, 100 $\mu$s);
- Measurement area: 150 $\times$ 150 $\mu$m²;
- Scan: 128 pixel $\times$ 128 pixel $\times$ 1 scan;
- Type of etching gun: Cs (1 keV, 60 nA);
- Etching area: 600 $\times$ 600 $\mu$m²;
- Etching rate: 10 sec/cycle; and
- Vacuuming time: 15 hours or more at $1 \times 10^{-6}$ mbar or less.
- TOF-SIMS measurement was performed within 30 hours after the start of vacuuming.

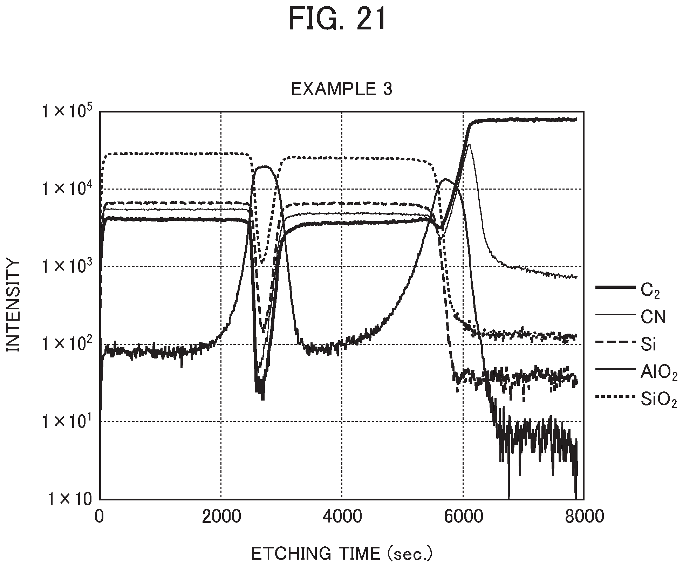

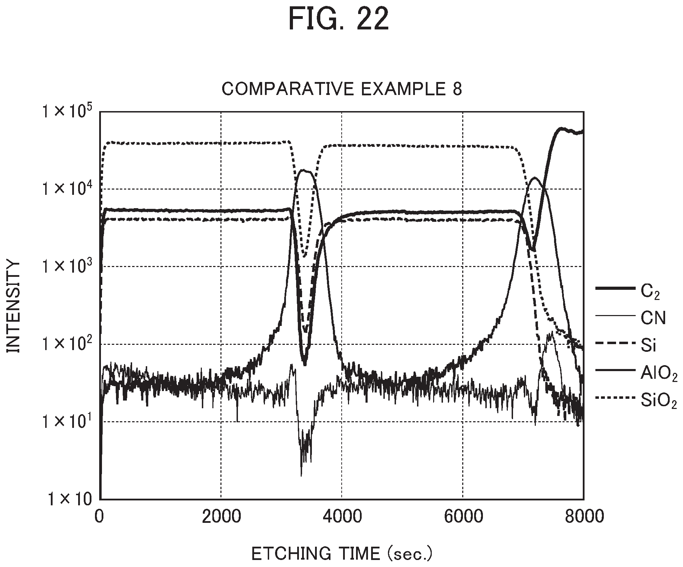

The graph analysis charts of measurement results are shown in Figs. 20 to 22. Fig. 20 is measurement results of Example 2, Fig. 21 is measurement results of Example 3, and Fig. 21 is measurement results of Comparative Example 8. In the graphs, the unit (intensity) of the vertical axis is the intensity of secondary ions, and the unit (Et times (s)) of the horizontal axis is the number of seconds of etching performed.

# EP 4 786 162 A1

[Table 4]

| | XAFS peak top ratio | C2/Si intensity ratio of TOF-SIMS | |
| --- | --- | --- | --- |
| | | First covering layer | Second covering layer |
| Example 1 | 1.06 | 0.91 | 0.92 |
| Example 2 | 1.09 | 0.91 | 0.92 |
| Example 3 | 1.07 | 0.57 | 0.61 |
| Example 4 | 1.07 | 0.56 | 0.60 |
| Example 5 | 1.30 | 0.92 | 0.94 |
| Example 6 | 1.54 | 0.92 | 0.94 |
| Example 7 | 1.05 | 0.91 | 0.92 |
| Comparative Example 1 | 0.68 | 0.79 | - |
| Comparative Example 2 | 0.81 | 0.79 | - |
| Comparative Example 3 | 0.83 | 0.79 | - |
| Comparative Example 4 | 1.28 | 0.92 | - |
| Comparative Example 5 | 1.29 | 0.92 | - |
| Comparative Example 6 | 0.75 | 0.91 | 0.92 |
| Comparative Example 7 | 0.81 | 0.91 | 0.92 |
| Comparative Example 8 | 0.93 | 0.80 | 0.77 |
| Comparative Example 9 | 1.00 | 0.91 | 0.92 |
| Comparative Example 10 | 1.65 | - | - |

<Color irregularity evaluation of external end surface of barrier film>

The end surface visual appearance of the wound body of each of the barrier films of Example 1 to 7 and Comparative Examples 1 to 9 was inspected from the end surface. Furthermore, the barrier films of Comparative Examples 1 and 3 to 5 were each taken from the wound body, and the "color difference" was evaluated. The results are shown in Table 4. Here, "end surface visual appearance" is visual evaluation of color irregularity evaluation when viewed from the end surface side (side surface side) of a wound body. The evaluation of "color difference" was performed as follows. Barrier films were taken from a dark colored area (A) and a light colored area (B) when the barrier film wound body was viewed from the end surface side. A piece of the barrier film of the dark colored area (A) was placed on a standard while board with the film side facing up, and measurement was performed using a spectral colorimeter CM-600d manufactured by Konica Minolta, Inc. under conditions of SCI (specular reflection included), 10° field of view, and D65 light source. The light colored area (B) was also measured similarly. The color difference between the dark colored area (A) and the light colored area (B) was determined from the measured $L^*$, $a^*$, and $b^*$ values. It was confirmed that when the color difference was 0.3 or more in one piece of a barrier film, the color irregularity viewed from the end surface of the wound body was judged to be strong by the visual appearance inspection.

[Table 5]

| | Color irregularity in end surface visual appearance | $L^*$, $a^*$, and $b^*$ measured value of dark colored area (A) | | | $L^*$, $a^*$, and $b^*$ measured value of light colored area (B) | | | Color difference between (A) and (B) |
| --- | --- | --- | --- | --- | --- | --- | --- | --- |
| | | $L^*$ | $a^*$ | $b^*$ | $L^*$ | $a^*$ | $b^*$ | $\Delta E^*ab$ |
| Example 1 | Weak | - | - | - | - | - | - | - |
| Example 2 | Weak | - | - | - | - | - | - | - |
| Example 3 | Weak | - | - | - | - | - | - | - |
| Example 4 | Weak | - | - | - | - | - | - | - |

(continued)

| | Color irregularity in end surface visual appearance | L*, a*, and b* measured value of dark colored area (A) | | | L*, a*, and b* measured value of light colored area (B) | | | Color difference between (A) and (B) |
|---|---|---|---|---|---|---|---|---|
| | | L* | a* | b* | L* | a* | b* | ΔE*ab |
| Example 5 | Weak | - | - | - | - | - | - | - |
| Example 6 | Weak | - | - | - | - | - | - | - |
| Example 7 | Weak | - | - | - | - | - | - | - |
| Comparative Example 1 | Strong | 98.6 | -0.19 | 0.91 | 98.7 | -0.19 | 0.38 | 0.54 |
| Comparative Example 2 | Strong | - | - | - | - | - | - | - |
| Comparative Example 3 | Strong | 98.8 | -0.18 | 0.74 | 99.0 | -0.19 | 0.37 | 0.42 |
| Comparative Example 4 | Weak | 99.2 | -0.19 | 0.32 | 99.3 | -0.19 | 0.30 | 0.10 |
| Comparative Example 5 | Weak | 98.8 | -0.15 | 0.49 | 99.0 | -0.18 | 0.45 | 0.21 |
| Comparative Example 6 | Strong | - | - | - | - | - | - | - |
| Comparative Example 7 | Strong | - | - | - | - | - | - | - |
| Comparative Example 8 | Strong | - | - | - | - | - | - | - |
| Comparative Example 9 | Strong | - | - | - | - | - | - | - |
| Comparative Example 10 | - | - | - | - | - | - | - | - |

<Measurement of barrier properties of barrier film>

The values of the water vapor transmittance and oxygen transmittance of the barrier films of Examples 1 to 7 and Comparative Examples 1 to 9 were measured.

The water vapor transmittance (g/(m$^2$·day), in the table, expressed as "WVTR") was measured with a water vapor transmittance measurement apparatus (manufactured by MOCON, Inc., production name: "PERMATORAN-W 3/31") under measurement conditions of 40°C and 100% RH in accordance with JIS K 7129 B method. The oxygen transmittance (cc/(m$^2$·day·atm), in the table, expressed as "OTR") was measured with an oxygen transmittance measurement apparatus (manufactured by MOCON, Inc., production name: "OX-TRAN 2/20") under measurement conditions of 23°C and 90% RH in accordance with JIS K 7126-2. The results are shown in Table 6.

<Evaluation of luminance retention rate>

Wavelength conversion sheets having the following layer structure were produced using the barrier films of Examples 1 to 7 and Comparative Examples 1 to 9.

A matte layer 160 was formed on one surface of a support 150 (biaxially oriented PET film, thickness: 38 μm), and a sticky adhesive layer 140 (2-part curing polyurethane adhesive, dried film thickness: 5 μm) was then applied and dried by gravure roll coating and was laminated to the surface of the barrier film 130 of Example 1 on the covering layer side to obtain two laminates 100D shown in Fig. 9.

The matte layer 160 was formed by mixing spherical particles (Epostar MA (resin that is an acrylic crosslinked product having a compressive strength of 2.8 kgf/mm$^2$ or more, average particle diameter; 4 μm)) containing a polyacrylic resin as the particles 162 and an acrylic resin as the resin to produce a matte layer-forming coating agent and applying the agent onto the base material by gravure roll coating (particle content: 1.7 mass%, dried application amount: 1.6 g/m$^2$, matte layer thickness: 1.5 μm).

Then, the following adhesive layer application solution was applied onto the surface of the base material 120, followed by drying to form an adhesive layer 170.

<Adhesive layer application solution>

- Polyester polyol: 50 parts by mass
  (hydroxyl group value: 62 mg KOH/g, solid content: 20 mass%);
- Silane coupling agent: 1 part by mass
  (3-glycidoxypropylmethyldimethoxysilane);
- Silica filler: 1 part by mass
  (average particle diameter: 5 μm);
- Curing agent: 1 part by mass
  (1,6-hexamethylene diisocyanate, solid content mass: 35%); and
- Solvent: 50 parts by mass
  (methyl ethyl ketone).

Furthermore, a fluorescent substance application solution containing the fluorescent substance 112 below was applied to the surface of the adhesive layer 170 formed on surface of the base material 120 of one of the laminates 100D, followed by drying to form a fluorescent substance layer 110 not exposed to ionizing radiation. Subsequently, the fluorescent substance layer 110 not exposed to ionizing radiation and the other laminate 100D were laminated such that the base materials 120 faced each other, followed by irradiation with UV light to manufacture the wavelength conversion sheet 200D shown in Fig. 11 in which two laminates 100D were laminated with a fluorescent substance layer 110 having a thickness of 30 μm therebetween.

<Fluorescent substance dispersion>

Quantum dots and amino-modified silicone were mixed in the following composition ratio in a glove box purged with nitrogen such that the oxygen concentration was 300 ppm or less and were stirred with a magnetic stirrer for 4 hours in a water bath of 90°C. Subsequently, the resulting solution was filtered through a polypropylene filter with a hole diameter of 0.2 μm to obtain a CdSe/ZnS core-shell quantum dot dispersion.

- Quantum dot: 0.9 parts by mass
  (light emission peak: 540 nm, manufactured by Sigma-Aldrich);
- Quantum dot: 0.9 parts by mass
  (light emission peak: 630 nm, manufactured by Sigma-Aldrich); and
- Amino-modified silicone: 99 parts by mass
  (manufactured by Genesee Scientific, GP-344, viscosity: 670 mPa·s).

<Fluorescent substance application solution>

- Multifunctional acrylate compound: 58.11 parts by mass (ethoxylated bisphenol A diacrylate, available from Shin-Nakamura Chemical Co., Ltd., trade name: "ABE-300");
- Multifunctional thiol compound: 38.74 parts by mass (pentaerythritol tetrakis(3-mercaptopropionate), available from SC Organic Chemical Co., Ltd., trade name: "PEMP");
- Photopolymerization initiator: 0.5 parts by mass
  (available from IGM Resins B.V., trade name "Omnirad TPO H"); T-he above-mentioned fluorescent substance dispersion: 1.61 parts by mass;
- Acetic acid: 0.79 parts by mass; and
- Titanium oxide: 0.25 parts by mass
  (available from Chemours, trade name: "Ti-Pure R-706", particle diameter: 0.36 μm).

Similarly, wavelength conversion sheets including the barrier films of Examples and Comparative Examples were manufactured using barrier films of Examples 2 to 4 and Comparative Examples 1 to 10 instead of the barrier film 130 of Example 1. After the manufacturing, the wavelength conversion sheets were each wound into a roll.

Each of the wavelength conversion sheets obtained above was cut into a size of 100 mm in width and 100 mm in length to obtain a sample for evaluation. The spectral radiance of the evaluation sample was measured using a spectroradiometer SR-LEDW (Topcon Corporation). The luminances at the peak tops near wavelengths of 449 nm, 535 nm, and 627 nm were taken as the luminances of blue, green, and red, respectively. The spectroradiometer was installed on top, and under the object lens of the spectroradiometer, a dual brightness enhancement film (DBEF), a brightness enhancement film (BEF), the evaluation sample, a light diffusion plate, and a blue LED light source were placed in this order, and the spectral radiance was measured. The measurement angle was set to 0.1°.

The evaluation sample used for the above measurement was subjected to a wet heat test by being left to stand in a thermos-hygrostat of 60°C and 90% RH for 1,000 hours, and then the luminance was measured by the same method as above. Subsequently, the luminance retention rate of each evaluation sample was calculated according to the following equation. The results are shown in Table 5. Luminance retention rate (535 nm) = (Ga/Ba)/(Gb/Bb)×100 (%); and

Luminance retention rate (627 nm) = (Ra/Ba)/(Rb/Bb)×100 (%),
Ba: emission intensity (luminance) of peak top at around 449 nm after wet heat test;
Ga: emission intensity (luminance) of peak top at around 535 nm after wet heat test;
Ra: emission intensity (luminance) of peak top at around 627 nm after wet heat test;
Bb: emission intensity (luminance) of peak top at around 449 nm before wet heat test;
Gb: emission intensity (luminance) of peak top at around 535 nm before wet heat test; and
Rb: emission intensity (luminance) of peak top at around 627 nm before wet heat test.

[Table 6]

|  | Barrier film alone | | Luminance retention rate | |
|---|---|---|---|---|
|  | OTR | WVTR | 535nm | 627nm |
| Example 1 | <0.10 | <0.10 | 92% | 94% |
| Example 2 | <0.10 | <0.10 | 90% | 93% |
| Example 3 | <0.10 | <0.10 | 91% | 93% |
| Example 4 | <0.10 | <0.10 | 91% | 93% |
| Example 5 | <0.10 | <0.10 | 90% | 91% |
| Example 6 | <0.10 | <0.10 | 91% | 93% |
| Example 7 | <0.10 | <0.10 | 93% | 94% |
| Comparative Example 1 | 0.11 | 0.30 | 57% | 60% |
| Comparative Example 2 | 0.12 | 0.25 | 52% | 56% |
| Comparative Example 3 | 0.12 | 0.24 | 55% | 57% |
| Comparative Example 4 | 0.09 | 0.50 | 45% | 52% |
| Comparative Example 5 | 0.23 | 0.68 | 41% | 48% |
| Comparative Example 6 | <0.10 | <0.10 | 96% | 97% |
| Comparative Example 7 | <0.10 | <0.10 | 96% | 97% |
| Comparative Example 8 | <0.10 | <0.10 | 95% | 96% |
| Comparative Example 9 | <0.10 | <0.10 | 95% | 96% |
| Comparative Example 10 | - | - | - | - |

It was demonstrated from Tables 4 to 6 that the laminates including the barrier films according to the present embodiments, the peak top ratio P obtained from the XAFS spectrum is 1.05 or more and less than 1.60, the barrier film does not have color irregularity, and the luminance retention rate when used in a wavelength conversion sheet is high.

EXPLANATION OF REFERENCE NUMERALS

100A barrier film
100B to 100D laminate
110 fluorescent substance layer
111 sealing resin
112 fluorescent substance
1, 120 base material

131b first deposition film
131a first covering layer
132b second deposition film
132a second covering layer
140 tackifier layer or adhesive layer
150 support
160 matte layer
161 resin
162 particle
170 tackifier layer or adhesive layer
200B, 200D wavelength conversion sheet
300A, 300B display device
310, 380 light source
320 reflection sheet
330 light guide plate
340 prism sheet
350 polarization-selective reflection sheet
360 liquid crystal panel (LCD panel)
370 diffusion plate
10 film-forming apparatus
P plasma
X rotation axis
11A base material-transporting mechanism
11B plasma pretreatment mechanism
11C film-forming mechanism
12 decompression chamber
12A base material transport room
12B plasma pretreatment room
12C film-forming room
13 unwinding roller
14a to 14d guide roller
15 winding roller
20 pretreatment roller
21 electrode section
23 magnetic field-forming section
23a first surface
23b second surface
231 first magnet
231c first axis direction portion
232 second magnet
232c second axis direction portion
232d connection portion
24 evaporation mechanism
24b boat
25 film-forming roller
31 power supply wiring
32 power source
35a to 35c partition wall
50 plasma supply mechanism
51 hollow cathode
61 vapor deposition material supply section
63 aluminum vapor

**Claims**

1. A barrier film comprising a resin base material, a first aluminum oxide deposition film, a first covering layer, a second aluminum oxide deposition film, and a second covering layer laminated in this order,

the first covering layer and the second covering layer being each a cured product of a resin composition containing an alkoxysilane and a hydroxyl group-containing water-soluble resin, and

the first aluminum oxide deposition film and the second aluminum oxide deposition film each having a deposition film peak top ratio P of 1.05 or more and 1.60 or less defined by the following equation when X-ray absorption fine structure analysis is performed from the surface side of the second covering layer of the barrier film:

P = (intensity peak top at around 1,572 eV) / (intensity peak top at around 1,566 eV).

2. The barrier film according to claim 1, wherein when the barrier film is etched from the surface side opposite to the resin base material by time-of-flight secondary ion mass spectrometry (TOF-SIMS), a covering layer intensity ratio X defined by an equation below, where the intensity is detected in each of regions of the first covering layer and the second covering layer, is 0.50 or more and 1.10 or less:

$$X = C_2^- \text{ ion intensity} / Si^- \text{ ion intensity}.$$

3. The barrier film according to claim 1, wherein a matte layer is disposed on the resin base material on the side opposite to the first aluminum oxide deposition film.

4. A laminate comprising the barrier film according to claim 1 and a support laminated with a sticky adhesive layer therebetween.

5. The laminate according to claim 4, wherein a matte layer is disposed on the support on the side opposite to the sticky layer.

6. A wavelength conversion sheet comprising the barrier film according to claim 3 and a fluorescent substance layer disposed therebetween.

7. A wavelength conversion sheet comprising the laminates according to claim 4 and a fluorescent substance layer disposed therebetween, wherein the laminates are each disposed such that the support, the resin base material, the covering layer, and the fluorescent substance layer are arranged in this order from the outermost layer side.

8. A wavelength conversion sheet comprising the laminates according to claim 4 and a fluorescent substance layer disposed therebetween, wherein the laminates are each disposed such that the support, the covering layer, the resin base material, and the fluorescent substance layer are arranged in this order from the outermost layer side.

9. A wavelength conversion sheet comprising the laminates according to claim 4 and a fluorescent substance layer disposed therebetween, wherein one of the laminates is disposed such that the support, the resin base material, the covering layer, and the fluorescent substance layer are arranged in this order from the outermost layer side, and the other laminate is disposed such that the support, the covering layer, the resin base material, and the fluorescent substance layer are arranged in this order from the outermost layer side.

10. A backlight member comprising a light source, a light-guiding plate or light-diffusing plate, and the wavelength conversion sheet according to claim 6.

11. A surface-mounted display device comprising a light-guiding plate,

the display device having a liquid crystal panel, a polarization-selective reflection sheet, a prism sheet, the wavelength conversion sheet according to claim 6, the light-guiding plate, and a reflection sheet sequentially laminated therein, and

having a light source section disposed on an end surface of the light-guiding plate.

12. A direct-type display device comprising a light-diffusing plate, the display device having a liquid crystal panel, a polarization-selective reflection sheet, a prism sheet, the wavelength conversion sheet according to claim 6, the light-diffusing plate, a light source section, and a reflection sheet sequentially laminated therein.

# FIG. 1

100A

132a
132b
131a
131b
130
120

FIG. 2

EP 4 786 162 A1

# FIG. 3

# FIG. 4

# FIG. 5

# FIG. 6

FIG. 7

100B

132a
132b
131a
131b
130

120

161

162

160

# FIG. 8

100C

132a
132b  ⎫
131a  ⎬ 130
131b  ⎭
120
140
150
161
160
162

# FIG. 9

100D

| | |
|---|---|
| | 120 |
| | 131b |
| | 131a |
| | 132b |
| | 132a |
| | 140 |
| | 150 |
| 161 | 160 |

130

162

# FIG. 10

200B

160
120
131b
131a
132b
132a
} 100B
170
112
111
110
170
132a
132b
131a
131b
120
160
} 100B
161
162

# FIG. 11

200D

160
150
140
132a
132b
131a
131b
120
170
110
170
120
131b
131a
132b
132a
140
150
160

100D

100D

112
111

161
162

# FIG. 12

300A

360

350

340

200B(200D)

310

330

320

# FIG. 13

300A

360

350

340

200B(200D)

310

330

320

# FIG. 14

300B

360

350

340

200B(200D)

370

380

320

# FIG. 15

EXAMPLE 2

# FIG. 16

EXAMPLE 2

# FIG. 17

COMPARATIVE EXAMPLE 2

# FIG. 18

COMPARATIVE EXAMPLE 4

# FIG. 19

COMPARATIVE EXAMPLE 8

# FIG. 20

EXAMPLE 2

# FIG. 21

## EXAMPLE 3

# FIG. 22

COMPARATIVE EXAMPLE 8

## INTERNATIONAL SEARCH REPORT

International application No.

**PCT/JP2024/034697**

### A. CLASSIFICATION OF SUBJECT MATTER

***B32B 9/00***(2006.01)i; ***B32B 7/12***(2006.01)i; ***B32B 9/04***(2006.01)i; ***C23C 14/08***(2006.01)i; ***G02B 5/30***(2006.01)i
FI: B32B9/00 A; B32B7/12; B32B9/04; C23C14/08 A; G02B5/30

According to International Patent Classification (IPC) or to both national classification and IPC

### B. FIELDS SEARCHED

Minimum documentation searched (classification system followed by classification symbols)

B32B1/00-43/00; C23C14/00-14/58; G02B5/30

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2022-142333 A (DAI NIPPON PRINTING CO., LTD.) 30 September 2022 (2022-09-30) entire text | 1-12 |
| A | JP 2020-49941 A (DAI NIPPON PRINTING CO., LTD.) 02 April 2020 (2020-04-02) entire text | 1-12 |
| A | JP 2023-127642 A (TORAY ADVANCED FILM CO., LTD.) 14 September 2023 (2023-09-14) entire text | 1-12 |
| A | JP 2017-24369 A (TORAY INDUSTRIES, INC.) 02 February 2017 (2017-02-02) entire text | 1-12 |
| A | JP 2017-65054 A (TORAY INDUSTRIES, INC.) 06 April 2017 (2017-04-06) entire text | 1-12 |
| A | JP 6-210790 A (TOYO BOSEKI KABUSHIKI KAISHA) 02 August 1994 (1994-08-02) entire text | 1-12 |

☐ Further documents are listed in the continuation of Box C.  ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **06 November 2024** | **19 November 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

**INTERNATIONAL SEARCH REPORT**
Information on patent family members

International application No.

**PCT/JP2024/034697**

| Patent document cited in search report | | | Publication date (day/month/year) | Patent family member(s) | Publication date (day/month/year) |
|---|---|---|---|---|---|
| JP | 2022-142333 | A | 30 September 2022 | (Family: none) | |
| JP | 2020-49941 | A | 02 April 2020 | (Family: none) | |
| JP | 2023-127642 | A | 14 September 2023 | (Family: none) | |
| JP | 2017-24369 | A | 02 February 2017 | (Family: none) | |
| JP | 2017-65054 | A | 06 April 2017 | (Family: none) | |
| JP | 6-210790 | A | 02 August 1994 | (Family: none) | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017177343 A
- JP 2022052319 A
- WO 2015037733 A